(19) Europäisches Patentamt / European Patent Office / Office européen des brevets

(11) **EP 2 836 998 B1**

(12) **FASCICULE DE BREVET EUROPEEN**

(45) Date de publication et mention
de la délivrance du brevet:
**06.05.2020 Bulletin 2020/19**

(21) Numéro de dépôt: **13720462.4**

(22) Date de dépôt: **09.04.2013**

(51) Int Cl.:
*G11C 11/16* *(2006.01)*    *G11C 11/15* *(2006.01)*
*G11C 11/56* *(2006.01)*    *G11C 11/155* *(2006.01)*

(86) Numéro de dépôt international:
**PCT/FR2013/050764**

(87) Numéro de publication internationale:
**WO 2013/153321 (17.10.2013 Gazette 2013/42)**

(54) **DISPOSITIF MAGNETIQUE A ECRITURE ASSISTEE THERMIQUEMENT**

MAGNETVORRICHTUNG MIT WÄRMEUNTERSTÜTZTEM SCHREIBVERFAHREN

MAGNETIC DEVICE WITH THERMALLY-ASSISTED WRITING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.04.2012 FR 1253251**

(43) Date de publication de la demande:
**18.02.2015 Bulletin 2015/08**

(73) Titulaire: **Commissariat à l'Énergie Atomique
et aux Énergies Alternatives
75015 Paris (FR)**

(72) Inventeur: **DIENY, Bernard
F-38250 Lans en Vercors (FR)**

(74) Mandataire: **Lebkiri, Alexandre et al
Cabinet Camus Lebkiri
25, Rue de Maubeuge
75009 Paris (FR)**

(56) Documents cités:
EP-A2- 1 622 161    US-A1- 2008 180 989
US-A1- 2009 147 567    US-A1- 2011 110 151
US-B1- 6 654 278

- **METLOV KONSTANTIN ET AL: "Map of metastable states for thin circular magnetic nanocylinders", APPLIED PHYSICS LETTERS, AIP, AMERICAN INSTITUTE OF PHYSICS, MELVILLE, NY, US, vol. 92, no. 11, 19 mars 2008 (2008-03-19) , pages 112506-112506, XP012106027, ISSN: 0003-6951, DOI: 10.1063/1.2898888**

EP 2 836 998 B1

**Description**

La présente invention concerne un dispositif magnétique de type mémoire MRAM (Magnetic Random Access Memory) ou élément logique (« Magnetic Logic Unit ») à base d'éléments magnétiques magnétorésistifs et à écriture assistée thermiquement.

Le document US2009/147567 décrit un dispositif MRAM à écriture assistée thermiquement. Les mémoires magnétiques MRAM ont connu un regain d'intérêt avec la mise au point de jonctions tunnels magnétiques présentant une forte magnétorésistance à température ambiante. Les mémoires MRAM comportent généralement plusieurs points mémoires. Ces points mémoires sont généralement des dispositifs magnétiques qui comportent :

- une couche magnétique appelée « couche de référence » qui présente une aimantation dont la direction est fixe ;
- une couche magnétique appelée « couche de stockage » qui présente une aimantation dont la direction est variable et qui peut s'orienter soit parallèlement, soit antiparallèlement à la direction d'aimantation de la couche de référence ;
- un espaceur réalisé dans un matériau isolant ou semi-conducteur qui sépare la couche de référence et la couche de stockage.

Le document FR2817999 décrit par exemple un tel dispositif magnétique. Chaque point mémoire présente deux modes de fonctionnement : un mode « lecture » et un mode « écriture ». Lors du mode écriture, un courant d'électrons est envoyé à travers les couches ou un champ magnétique est appliqué sur la couche de stockage du point mémoire, de façon à provoquer le retournement de la direction d'aimantation de la couche de stockage, qui devient alors parallèle ou antiparallèle à la direction d'aimantation de la couche de référence. Suivant que la direction d'aimantation de la couche de stockage est parallèle ou antiparallèle à la direction d'aimantation de la couche de référence, un « 1 » ou un « 0 » est stocké dans la couche de stockage. Lors du mode lecture, un courant d'électrons est injecté à travers le point mémoire de façon à lire sa résistance. Lorsque les directions d'aimantation de la couche de référence et de la couche de stockage sont parallèles, la résistance du point mémoire est faible, tandis que lorsque les directions d'aimantation des couches de référence et de stockage sont antiparallèles, la résistance du point mémoire est élevée. Par comparaison avec une résistance de référence, la valeur stockée dans la couche de stockage (« 0 » ou « 1 ») peut être déterminée.

Toutefois, les valeurs des résistances lorsque les couches de référence et de stockage sont parallèles ou antiparallèles peuvent varier d'un point mémoire à l'autre. Par conséquent, lorsque l'on compare la résistance d'un point mémoire à une valeur de référence standard, le résultat de la comparaison n'est parfois pas représentatif de l'état réel du point mémoire du fait des différences entre ce point mémoire et le point mémoire qui a permis d'établir la valeur de référence standard.

Pour remédier à ce problème, des dispositifs magnétiques ont été mis au point qui comportent une couche de référence dont la direction d'aimantation est variable.

Ainsi, le document EP2276034 décrit un dispositif magnétique qui comporte des points mémoires, chaque point mémoire comportant :

- une couche de stockage ;
- un espaceur ;
- une couche de référence dont la direction d'aimantation est variable ;
- un conducteur qui, lorsqu'il est traversé par un courant d'électrons, génère un champ magnétique, la direction du courant d'électrons pouvant être choisie de façon à contrôler la direction du champ magnétique généré ;
- des moyens d'injection d'un courant d'électrons à travers le point mémoire.

Ce dispositif est particulièrement avantageux car il permet de lire l'information stockée dans la couche de stockage sans avoir à utiliser de valeur de résistance de référence. En effet, ce dispositif magnétique permet de réaliser une lecture différentielle de l'information contenue dans la couche de stockage à l'aide de la couche de référence.

Pour cela, on mesure la résistance du point mémoire quand la direction d'aimantation de la couche de référence est dans un sens, puis on mesure la résistance de ce même point mémoire quand la direction d'aimantation de la couche de référence est dans l'autre sens. On compare ensuite les valeurs de ces deux résistances de façon à en déduire la direction de l'aimantation de la couche de stockage.

Pour cela, on oriente, avec un premier pulse de champ magnétique, la direction d'aimantation de la couche de référence dans un sens prédéterminé. On mesure alors la résistance du point mémoire. On applique ensuite un deuxième pulse de champ magnétique de façon à orienter la direction d'aimantation de la couche de référence dans le sens opposé au premier sens prédéterminé. On mesure alors à nouveau la résistance du point mémoire. Après chaque pulse de courant, on connaît la direction d'aimantation de la couche de référence, puisqu'on connaît la direction des pulses de champs magnétiques appliqués. Par conséquent, en comparant la résistance du point mémoire après le premier pulse de courant et après le deuxième pulse de courant, on en déduit la direction d'aimantation de la couche de stockage. Ce mode de lecture de l'information contenue dans la couche de stockage est particulièrement avantageux car il permet une lecture plus précise de l'information contenue dans la couche de stockage et d'avoir des résultats moins sensibles aux fluctuations de résistance d'un point mémoire à l'autre.

La meilleure précision de lecture est obtenue puisqu'on n'utilise plus de valeur de référence standard, mais on place un même point mémoire dans deux états et on compare ces deux états entre eux, ce qui permet d'avoir des résultats moins sensibles aux fluctuations de résistance d'un point mémoire à l'autre. Ceci permet de tolérer davantage de dispersion dans les résistances et amplitudes de magnétorésistance.

Par ailleurs, ce dispositif peut être utilisé comme un élément logique comprenant une fonction mémoire contenue dans l'orientation de l'aimantation de la couche de stockage et une fonction logique de comparaison contenue dans l'orientation relative des aimantations des couches mémoires et logique. Le nom de « Magnetic Logic Unit » (MLU) est parfois donné à cet élément.

Toutefois, le dispositif décrit dans ce document nécessite l'utilisation de courants relativement importants pour générer un champ magnétique permettant de faire commuter la direction d'aimantation de la couche de référence. A la lecture, la couche de référence doit être la plus douce possible pour consommer le moins d'énergie possible.

Le document US6654278 décrit un point mémoire ayant une couche de référence avec une configuration magnétique à l'état vortex ; le cœur de vortex peut se déplacer de manière très réversible avec un champ relativement faible. La couche de stockage est une couche magnétique présentant une forte anisotropie uniaxiale avec un axe de facile aimantation. Cette anisotropie uniaxiale est une anisotropie de forme obtenue en donnant à l'élément une forme allongée elliptique.

Même si le point mémoire du document US6654278 est présenté comme relativement stable, le risque d'écriture accidentelle lors de la lecture de l'information contenue dans la couche de stockage demeure bien présent, notamment en cas de forte densité de points mémoire. Par ailleurs, ce type de point mémoire dispose d'une capacité réduite à conserver l'information écrite au cours du temps (faible rétention). Ce type de point mémoire ne peut également stocker qu'un bit d'information du fait que l'aimantation de la couche de stockage n'a que deux états stables au repos c'est-à-dire hors écriture.

Par ailleurs, la fabrication de ce point mémoire n'est pas aisée car la couche de référence nécessite d'avoir un rapport de forme relativement faible (typiquement entre 1 et 1.3) pour que son aimantation puisse être en configuration vortex alors que la couche de stockage doit plutôt avoir une forme allongée (rapport de forme typiquement de 1.7 à 2.5) pour que son aimantation bénéficie d'une anisotropie de forme déterminante pour la rétention de l'information du point mémoire. Ainsi, le fait de devoir donner des formes différentes aux différentes couches constitutives de l'empilement complexifie grandement le processus de fabrication du point mémoire.

On connaît d'autres dispositifs de mémorisation magnétique de type MRAM utilisant un ensemble de points mémoires à l'état vortex. Le document US7072208 décrit un tel dispositif MRAM comportant une jonction tunnel magnétique incluant une couche libre et une couche de référence séparées par une barrière tunnel, chacune des deux couches étant dans un état vortex. Selon ce dispositif, on utilise la chiralité c de l'aimantation tournante (fixe dans le cas de la couche de référence et variable dans le sens horaire et antihoraire dans le cas de la couche libre) pour mesurer la variation de résistance et déterminer une information binaire « 0 » ou « 1 ». Le changement d'orientation de l'aimantation (horaire versus antihoraire) se fait en appliquant un champ statique de forte amplitude. Un tel dispositif est toutefois assez complexe à obtenir et nécessite beaucoup d'énergie pour la phase d'écriture et le retournement de la chiralité de l'aimantation. Par ailleurs, ce changement de chiralité de l'aimantation de la couche de stockage nécessite l'application de deux pulses de champ magnétique successifs soit bien contrôlés en intensité et durée pour induire la dynamique appropriée d'aimantation permettant le retournement de chiralité, soit suffisamment séparés en temps pour permettre une commutation quasi-statique de chiralité. Dans un cas comme dans l'autre ceci complexifie ou ralentit le processus d'écriture de l'information.

Par ailleurs ces dispositifs ne peuvent aussi stocker qu'un bit par élément magnétorésistif représenté par les deux chiralités d'aimantation possible du vortex formé par l'aimantation de la couche de stockage.

De plus dans certains modes de réalisations du dispositif du document US7072208, l'élément mémoire a une forme elliptique asymétrique constitué de deux demi ellipses accolées de petits axes de longueur différentes. La réalisation technologique d'un tel élément est difficile aux nœuds technologiques les plus avancés et la forme elliptique nuit à la densité de points mémoire que l'on peut stocker sur une puce par rapport à une forme proche de cylindrique.

Le document US2011/110151 décrit un dispositif magnétique à écriture assistée thermiquement.

L'invention vise à remédier aux inconvénients de l'état de la technique en proposant un dispositif magnétique qui permet l'utilisation de courants très faibles pour faire commuter la direction d'aimantation de la couche de référence tout en limitant le risque d'écriture accidentelle de la couche de stockage, notamment en présence d'une forte densité de points mémoire associés.

Pour ce faire, l'invention propose un dispositif magnétique à écriture assistée thermiquement comportant au moins un élément magnétique incluant :

- une première couche magnétique dite « couche de référence », la couche de référence présentant une aimantation en configuration vortex stable ;
- des moyens de création d'un champ magnétique pour déplacer de manière réversible le cœur du vortex dans le plan de ladite couche de référence ;

- une deuxième couche magnétique dite « couche de stockage », la couche de stockage présentant une configuration d'aimantation variable ;
- un espaceur non-magnétique qui sépare la couche de référence et la couche de stockage et les découple magnétiquement ;
- une couche antiferromagnétique de piégeage au contact de la couche de stockage, cette couche antiferromagnétique étant apte à piéger la configuration d'aimantation de la couche de stockage, ladite couche de stockage présentant un nombre strictement supérieur à deux de niveaux de stockage, chaque niveau de stockage correspondant à une configuration d'aimantation piégée;
- des moyens de chauffage de ladite couche antiferromagnétique de piégeage de sorte que, lors du chauffage, la température de ladite couche antiferromagnétique de piégeage dépasse sa température de blocage de sorte que à chaud, la configuration d'aimantation de ladite couche de stockage ne soit plus piégée.

L'élément magnétique peut être un point mémoire ou une unité logique.

On entend par état vortex une configuration magnétique cohérente dans des micro ou nanostructures magnétiques à aimantation dans le plan des couches présentant des rotations d'aimantation sur une échelle de longueur comparable à la dimension latérale de la surface de la couche concernée. L'état vortex d'aimantation résulte d'un équilibre entre énergie magnétostatique et énergie d'échange pour des micro ou nanostructures de couches magnétiques de forme cylindrique ou proche de cylindrique dont le rayon et l'épaisseur sont suffisamment grands. Pour ces couches, l'état vortex représente la configuration magnétique de plus basse énergie.

On entend par configuration en vortex stable le fait que le vortex peut se déformer réversiblement mais ne s'annihile pas ni ne change de chiralité dans les conditions normales de fonctionnement ;

On entend par « réversible » le fait que sous champ magnétique modéré, le vortex peut se déformer réversiblement, la partie de l'aimantation du vortex parallèle au champ appliqué ayant tendance à grossir et la partie de l'aimantation antiparallèle au champ appliqué ayant tendance à rétrécir. Ceci génère un déplacement du cœur de vortex dans la direction transverse à la direction du champ appliqué. Lorsque le champ magnétique diminue, le cœur de vortex revient graduellement vers sa position d'équilibre en champ nul. Dans le cas d'une microstructure ou nanostructure en forme de disque, la position d'équilibre du cœur de vortex correspond au centre du disque.

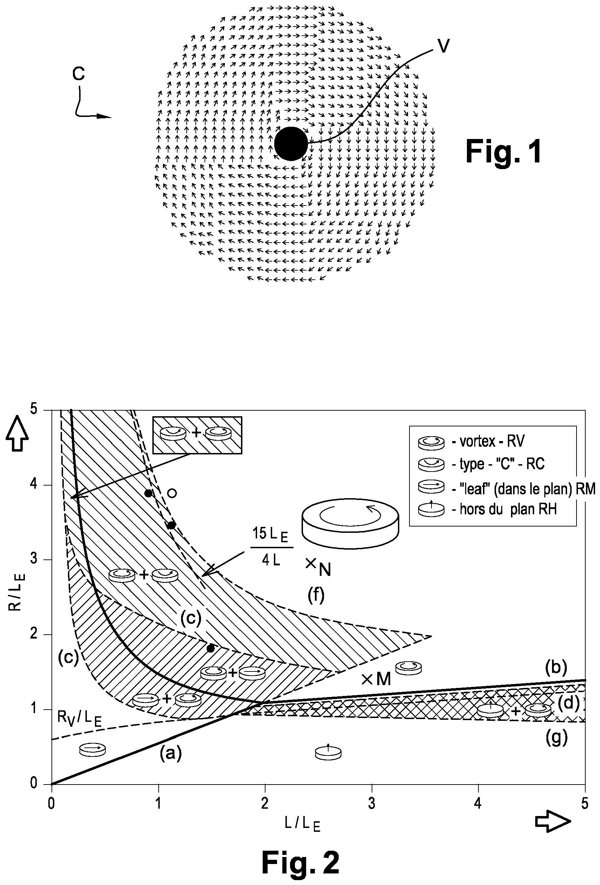

Une couche magnétique dans un état vortex possède une configuration magnétique spatialement inhomogène (i.e. l'aimantation a une orientation différente selon le point où l'on se trouve à l'intérieur de la couche). La figure 1 illustre l'orientation de l'aimantation sur une couche magnétique C dans un état vortex, la couche ayant ici une forme circulaire. On constate que l'aimantation (les vecteurs d'aimantation sont représentés par des flèches) se trouve dans le plan de la couche et tourne soit dans le sens horaire soit dans le sens contra-horaire (le sens horaire est ici représenté). L'aimantation adopte spontanément une configuration circulaire résultant d'une minimisation de l'énergie globale du système comprenant l'énergie d'échange qui tend à maintenir l'aimantation partout parallèle et de l'énergie magnétostatique qui tend à minimiser le champ rayonné à l'extérieur de la couche. Il existe donc une première dégénérescence de l'aimantation d'une couche dans un état vortex appelée chiralité dont le signe

$$c = \pm 1$$

dépend du sens dans lequel tourne l'aimantation dans le plan. On observe par ailleurs une singularité au centre de la cellule (dans une zone V appelée « cœur de vortex ») dans laquelle l'aimantation ne peut plus tourner sur une très courte échelle de longueur à cause du coût excessif en énergie d'échange associé à une telle rotation. Cette zone centrale V possède des dimensions qui sont sensiblement égales à la longueur caractéristique d'échange $L_E$ définie comme la longueur caractérisant la compétition entre énergie d'échange et énergie magnétostatique. Dans cette zone de cœur de vortex V, l'aimantation a tendance à sortir perpendiculairement au plan de la cellule vers le haut (on dira que l'aimantation ou polarité du cœur p est égale à +1) ou vers le bas (on dira alors que l'aimantation ou polarité du cœur p est égale à -1). On constate donc une seconde dégénérescence de la cellule dans l'état vortex selon que le cœur de vortex a une aimantation perpendiculaire au plan de la cellule vers le haut (p=+1) ou vers le bas (p=-1). Toutefois cette longueur d'échange est usuellement très courte (quelques nanomètres typiquement). Dans la présente description, la surface du point mémoire occupée par cette singularité d'aimantation est négligeable de sorte que l'influence de cette singularité sur les propriétés magnétiques et de magnétorésistance de l'élément considéré peut être négligée.

Selon l'invention, il est nécessaire que la couche magnétique de référence soit dans une configuration vortex stable. Pour ce faire, il est nécessaire que la configuration soit exclusivement vortex sans risque d'avoir d'autres types de configurations magnétiques, telles que par exemple une configuration monodomaine de type « feuille » ou « leaf » en anglais, une configuration de type « C », une configuration magnétique hors du plan ou la possibilité de coexistence de plusieurs de ces configurations (y-compris la coexistence d'une configuration vortex et d'une configuration non vortex). Les conditions de présence d'un état vortex stable d'une couche magnétique sont notamment décrites dans le document « Map of metastable states for thin circular magnetic nanocylinders » (Konstantin et al. - Applied Physics Letters 92, 112506 - 2008) ; la figure 2 illustre la répartition des types de configurations magnétiques obtenues en faisant varier le ratio $R/L_E$ (où R est le rayon de la couche magnétique circulaire dont on caractérise la configuration magnétique et $L_E$ est la longueur caractéristique d'échange) en fonction du ratio $L/L_E$ (où L est l'épaisseur de ladite couche) dans une couche magnétique sensiblement cylindrique. On constate qu'il est essentiel de choisir le rayon et l'épaisseur de la couche de façon à se trouver dans une région dans laquelle seule la configuration vortex est possible, correspondant sur le graphe à toute la région notée RV au-dessus à droite des zones hachurées (par exemple, le point M correspondant à une valeur $R/L_E$ égale à 1.4 et une valeur $L/L_E$ égale à 3 ou le point N correspondant à une valeur $R/L_E$ égale à 3 et une valeur $L/L_E$ égale à 2.5 ). On observe sur cette figure 2 qu'il est possible, selon les valeurs choisies, d'avoir une configuration monodomaine (région RM), une configuration vortex (région RV), une configuration hors du plan (région RH), la coexistence de configurations monodomaine et vortex, la coexistence de configurations vortex et de type « C », la coexistence de configurations hors du plan et vortex ou la coexistence de configurations de type « C » et vortex.

Dans les configurations connues de l'état de l'art où on utilise une couche de référence proche d'un état monodomaine, la lecture se fait en faisant commuter cette couche de référence d'une orientation donnée à l'orientation sensiblement opposée. Même dans le cas le plus favorable où on essaye de réaliser des piliers de forme quasi cylindrique, cette commutation nécessite des champs de plusieurs dizaines d'Oe (typiquement de 50 à 1000e) car il y a toujours des défauts de bord qui apparaissent lors du procédé de gravure de la jonction tunnel qui tendent à gêner la rotation de l'aimantation et peuvent même induire des états micromagnétiques incontrôlés pouvant même entraîner des erreurs de lecture. Au contraire, la configuration vortex stable utilisée selon l'invention est une configuration élastiquement déformable tant qu'on reste dans la région où le vortex se déforme sans s'annihiler (c'est à dire dans la gamme comprise entre + et - le champ d'annihilation). On peut le déformer avec l'application d'un champ petit sachant bien entendu que la déformation sera d'autant moins grande que le champ est petit (comme un élastique qui s'étend d'autant moins qu'on tire faiblement dessus). Toutefois, quelle que soit la déformation produite du vortex, celle-ci génèrera une variation de résistance électrique proportionnelle à la déformation et donc au champ appliqué. Si le circuit de détection est suffisamment sensible, on peut donc travailler avec des champs très petits, typiquement dans la gamme de l'ordre de 30 à 500e. Au contraire, selon l'état de l'art, on ne peut pas travailler avec un champ trop petit car si le champ est inférieur au champ coercitif de la couche de référence, celle-ci ne commutera pas et on ne mesurera pas de changement de résistance.

Le dispositif magnétique peut également présenter une ou plusieurs des caractéristiques ci-après, prises individuellement ou selon toutes les combinaisons techniquement possibles :

- les vortex de ladite couche de référence et de ladite couche de stockage ont la même chiralité ;
- ladite couche de stockage présente trois niveaux de stockage ;
- lesdits moyens de création d'un champ magnétique comportent des moyens pour créer deux composantes variables Hx et Hy de champ magnétique non parallèles, l'application simultanée de ces composantes de champ Hx et Hy étant apte à déplacer le cœur du vortex de ladite couche de stockage dans le plan de ladite couche de stockage lorsque celle-ci est non piégée, chaque couple de composantes Hx et Hy étant associé à un niveau de stockage ;
- ladite couche de référence et ladite couche de stockage présentent une même épaisseur et sont réalisées dans le même matériau ;
- le dispositif selon l'invention comporte une pluralité d'éléments magnétiques formant chacun un point mémoire, les vortex des couches de référence desdits points mémoire ayant tous la même chiralité ;
- pour un rayon donné dudit point mémoire, l'épaisseur de ladite couche de référence est choisie de sorte que ladite couche de référence présente une aimantation en configuration vortex stable ;
- la température de Curie de ladite couche de référence est réduite sur au moins une partie de l'épaisseur de cette couche de référence à une valeur inférieure à 900K mais supérieure à 550K.
- ladite couche de référence comporte une première sous-couche au contact dudit espaceur et une deuxième sous-couche, la première sous-couche ayant une température de Curie supérieure à la deuxième sous-couche plus éloignée dudit espaceur ;
- ladite couche de référence est une couche composite constituée d'au moins deux sous-couches incluant une sous-couche en CoFeB au contact de l'espaceur réalisé en MgO et une sous-couche à plus faible température de Curie plus éloignée de l'espaceur telle qu'une sous-couche en NiFe ou en alliage NiFeX où X représente un élément non magnétique tel que Ta, Cu, Hf, Zr, Cr, V dans une proportion de l'ordre de 2 à 20% ;
- ledit espaceur est réalisé selon l'une des formes suivantes :

  ○ ledit espaceur est une barrière tunnel ;
  ○ ledit espaceur est réalisé sous la forme d'une couche isolante comportant en son centre un contact conducteur ;

○ ledit espaceur est réalisé dans un matériau semiconducteur ou métallique ;

○ ledit espaceur est une couche métal/oxyde hétérogène comme une couche à chemins de courant confiné constituée d'une barrière isolante percée de canaux conducteurs ;

- ledit espaceur est réalisé sous la forme d'une couche isolante comportant en son centre un contact conducteur, lesdits moyens de création d'un champ magnétique étant adaptés pour déplacer ledit cœur de vortex par rapport au centre de ladite couche de référence d'une distance supérieure au rayon dudit cœur de vortex ;

- ladite couche de stockage comporte au moins un empilement formé par:

   ○ une couche constituée d'un matériau ferromagnétique présentant une structure cristallographie cubique face centrée au contact de ladite couche antiferromagnétique ;

   ○ une couche de transition amorphe ou quasi-amorphe au contact de ladite couche ferromagnétique présentant une structure cristallographie cubique face centrée;

   ○ une couche ferromagnétique présentant une structure cristallographique cubique centrée ;

- ledit au moins un point mémoire est de forme sensiblement cylindrique.

La présente invention a également pour objet une méthode de lecture de l'information contenue dans la couche de stockage d'un dispositif magnétique selon l'invention, ladite couche de stockage présentant une aimantation en configuration vortex stable, ladite méthode comportant une étape d'application d'un champ tournant sur l'aimantation de la couche de référence, ledit champ tournant provoquant une oscillation de la résistance de l'empilement, et une étape de détermination l'information écrite dans la couche de stockage à partir de la phase et de l'amplitude de ladite oscillation de résistance.

D'autres caractéristiques et avantages de l'invention ressortiront à la lecture de la description qui suit, en référence aux figures annexées :

- la figure 1 illustre la distribution d'aimantation sur une couche magnétique C dans un état vortex;

- la figure 2 illustre la répartition des types de configurations magnétiques obtenues en faisant varier le ratio $R/L_E$ en fonction du ratio $L/L_E$ dans une couche magnétique sensiblement cylindrique;

- la figure 3 représente un dispositif magnétique selon un mode de réalisation de l'invention ;

- la figure 4 représente l'évolution de l'aimantation d'une couche magnétique d'aimantation planaire sensiblement cylindrique initialement dans une configuration vortex sous l'effet d'un champ magnétique appliqué dans son plan ;

- les figures 5a à 5c illustrent la déformation d'une configuration vortex sous l'effet d'un champ magnétique ;

- les figures 6a à 6c illustrent les étapes d'un premier mode de réalisation d'un procédé d'initialisation de la chiralité du vortex dans un dispositif magnétique selon l'invention ;

- les figures 7a à 7c illustrent les étapes d'un second mode de réalisation d'un procédé d'initialisation de la chiralité du vortex dans un dispositif magnétique selon l'invention ;

- la figure 8 représente schématiquement l'écriture/lecture du dispositif magnétique de la figure 3 selon un premier mode de réalisation ;

- les figures 9a à 9c illustrent l'action d'un champ magnétique dans le cas d'une couche de stockage du dispositif magnétique selon l'invention dans une configuration initiale à l'état vortex ;

- Les figures 10a et 10b illustrent des exemples de signaux de tension obtenus lors d'une lecture dynamique du dispositif magnétique selon l'invention à deux niveaux de stockage ;

- Les figures 11a à 11c illustrent des exemples de signaux de tension obtenus lors d'une lecture dynamique du dispositif magnétique selon l'invention à trois niveaux de stockage ;

- les figures 12a à 12e illustrent l'action de deux champs magnétiques perpendiculaires dans le cas d'une couche de stockage du dispositif magnétique selon l'invention dans une configuration initiale à l'état vortex ;

- la figure 13 représente schématiquement l'écriture/lecture du dispositif magnétique de la figure 3 selon un second mode de réalisation

- la figure 14 représente la couche de stockage d'un dispositif selon l'invention comportant huit états de stockage ;

- La figure 15 représente la couche de stockage d'un dispositif selon l'invention comportant 16 états de stockage.

Pour plus de clarté, les éléments identiques ou similaires sont repérés par des signes de référence identiques sur l'ensemble des figures.

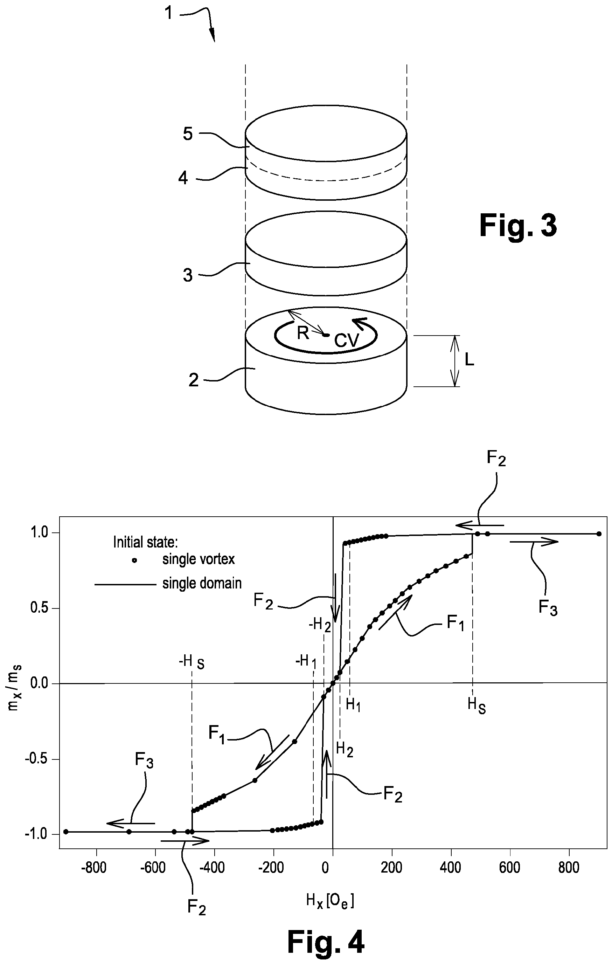

La figure 3 représente un dispositif magnétique 1 selon un mode de réalisation de l'invention.

Ce dispositif magnétique 1 comporte un seul point mémoire 1 mais nous verrons par la suite que le dispositif selon l'invention peut comporter plusieurs points mémoire. Les différentes couches du dispositif 1 sont ici préférentiellement circulaires de sorte que le dispositif magnétique 1 est de forme globalement cylindrique. Le dispositif magnétique 1 peut également être utilisé en tant qu'élément logique (« Magnetic Logic Unit »).

Ce dispositif magnétique comporte une couche de référence 2. Comme évoqué plus haut, la configuration magnétique de cette couche de référence 2 est celle d'un état vortex stable. La figure 2 montre qu'il est utile de choisir l'épaisseur L et le rayon R de sorte que la couche de référence 2 soit exclusivement à l'état vortex (i.e. sans coexistence possible avec un autre état magnétique métastable). Le rayon R est souvent fixé par des exigences de densité de points mémoire de sorte qu'on choisira l'épaisseur L telle que la couche de référence 2 soit dans la région vortex, c'est à dire dans la région RV du diagramme de la figure 2. En pratique, la longueur d'échange $L_E$ de la figure 2 est souvent de l'ordre de quelques nm (par exemple 5nm dans le cas du NiFe) de sorte que pour des rayons R de l'ordre de quelques dizaines de nm, le rapport $R/L_E$ est sensiblement égal à 10. On voit donc qu'il suffit d'augmenter l'épaisseur de la couche de référence pour tomber dans la région où la configuration vortex est stable.

La couche magnétique de référence 1 peut être une monocouche constituée d'un alliage cobalt-fer-bore ; cette couche de CoFeB peut toutefois être associée avec une couche de Ta ou Ti et à une autre couche douce, par exemple constituée d'un alliage fer-nickel. Dans tous les cas, l'épaisseur globale de la couche de référence sera choisie de manière appropriée pour se trouver dans une configuration vortex stable. On notera que la partie de la couche de référence 2 au contact de l'espaceur non magnétique 3, lorsque celui-ci est une barrière tunnel en MgO, est préférentiellement constituée d'un alliage CoFeB.

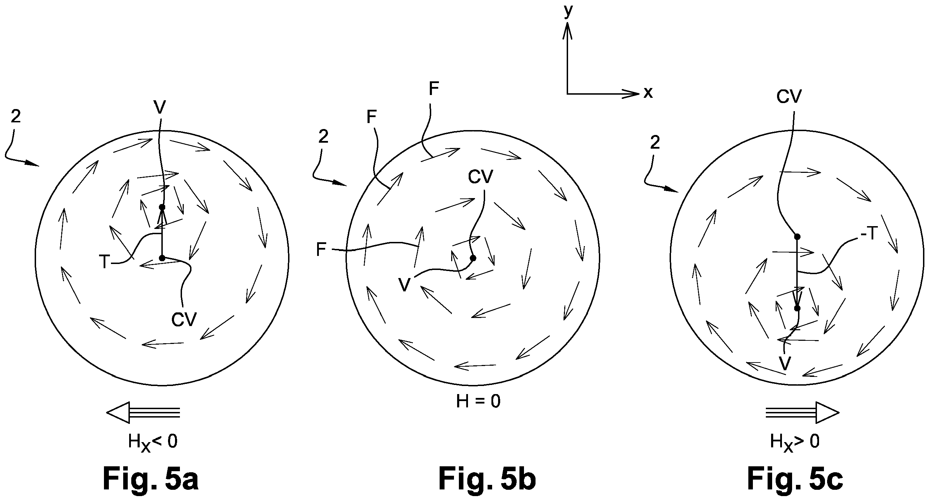

La configuration vortex de la couche de référence 2 présente une grande zone de stabilité lorsqu'elle est soumise à un champ magnétique. En d'autres termes, la configuration vortex reste présente sous l'effet d'un champ magnétique en se déformant de manière élastique et très réversible sur une large plage de champ jusqu'à un certain champ critique auquel le vortex s'annihile. Ce phénomène est illustré par les figures 4 et 5a à 5c. La figure 4 représente l'évolution de l'aimantation d'une couche magnétique sensiblement cylindrique initialement dans une configuration vortex sous l'effet d'un champ magnétique Hx. La distribution d'aimantation dans une telle couche magnétique 2 est illustrée en figure 5b lorsque le champ Hx est nul.

La couche 2 dans l'état vortex possède une configuration magnétique spatialement inhomogène (i.e. l'aimantation a une orientation différente selon le point où l'on se trouve), l'aimantation se trouve dans le plan de la couche 2 et tourne soit dans le sens horaire soit dans le sens contra-horaire (le sens horaire est ici représenté par les flèches F), le comportement circulaire de l'aimantation s'expliquant par la minimisation spontanée de l'énergie magnétostatique de la couche contrebalancée par un coût en énergie d'échange. On observe par ailleurs une singularité au centre du vortex CV dans une zone V appelée « cœur de vortex » dans laquelle l'aimantation n'arrive plus à tourner sur une aussi courte échelle spatiale. Sur la figure 5b, le cœur de vortex V est confondu avec le centre CV de la couche magnétique 2.

Comme expliqué précédemment, le rayon du cœur de vortex V est égal à la longueur d'échange $L_E$ qui dépend de la constante d'échange et de l'aimantation du matériau. Ce rayon est typiquement de quelques nanomètres.

La figure 4 montre dans le cas général l'effet d'un champ Hx appliqué à une couche magnétique de forme cylindrique similaire à la couche 2 du dispositif 1 selon l'invention. Pour un champ compris entre -Hs et Hs (Hs étant le champ d'annihilation du vortex), la configuration vortex demeure mais se déforme de manière élastique et réversible (flèche F1). Pour un champ supérieur à Hs ou inférieur à -Hs, le vortex s'annihile et la couche magnétique passe dans une configuration quasi monodomaine (flèche F3) ; Lorsque le champ diminue depuis la saturation, la configuration en vortex se renuclée en dessous d'un champ de valeur égale à H2 ou -H2 (flèche F2) correspondant au champ de nucléation du vortex. Ainsi l'annihilation et la nucléation de la configuration en vortex présente une hystérésis tandis que toute la partie correspondant à la déformation élastique du vortex est parfaitement réversible.

La déformation élastique de la configuration vortex est illustrée sur les figures 5a et 5c.

Pour un champ Hx négatif et supérieur à -Hs, c'est-à-dire appliqué suivant la direction -Ox, (figure 5a), le cœur de vortex V se déplace transversalement par rapport au champ appliqué suivant la direction Oy. Dès que l'on cesse l'application du champ, le cœur de vortex revient dans la position initiale telle que représentée en figure 5b selon un comportement totalement élastique et réversible. En d'autres termes, le cœur de vortex V est translaté d'un vecteur T par rapport au centre CV de la couche 2. Le cœur de vortex V se déplace de façon à favoriser l'orientation de l'aimantation moyenne du vortex selon la direction du champ Hx (i.e. ici la zone basse du vortex dans laquelle l'aimantation est préférentiellement dirigée suivant le champ Hx est agrandie).

Pour un champ Hx positif et inférieur au champ d'annihilation Hs et appliqué suivant la direction Ox (figure 5c), le cœur de vortex CV se déplace transversalement par rapport au champ appliqué suivant la direction -Oy. Dès que l'on cesse l'application du champ, le cœur de vortex revient dans la position initiale telle que représentée en figure 5b selon un comportement totalement élastique et réversible. En d'autres termes, le cœur de vortex V est translaté d'un vecteur -T par rapport au centre CV de la couche 2. A nouveau, le cœur de vortex V se déplace de façon à favoriser l'orientation de l'aimantation moyenne du vortex selon la direction du champ Hx (i.e. ici la zone haute du vortex dans laquelle l'aimantation est préférentiellement dirigée suivant le champ Hx est agrandie).

L'aimantation moyenne de la configuration magnétique non déformée (figure 5b) est quasi nulle du fait de sa symétrie cylindrique.

La déformation du vortex dans l'une des deux directions se traduit par une modification de l'aimantation moyenne suivant -Ox ou +Ox.

Selon l'invention, on cherche à obtenir une déformation du vortex assez aisée, c'est-à-dire ne nécessitant pas des intensités de champ trop importantes.

Pour ce faire, il convient d'obtenir une pente de la courbe de déformation élastique telle qu'illustrée en figure 4 (selon les flèches F1) la plus grande possible. Cette pente est inversement proportionnelle à la constante d'échange A (« exchange stiffness constant » en anglais). Dès lors, on peut ajuster la susceptibilité du vortex en jouant sur la constante d'échange du matériau ou des matériaux utilisé(s) pour la couche de référence 2. Plus la constante d'échange est élevée, plus la rigidité du vortex est grande. Il est à noter que cette constante d'échange est proportionnelle à la température d'ordre (c'est-à-dire la température de Curie) du matériau ferromagnétique

On choisira donc préférentiellement des matériaux pour lesquels la constante d'échange n'est pas trop grande. Cette constante d'échange est liée à la température de Curie du matériau. Pour cela, il est intéressant d'utiliser une couche de référence composite constituée d'au moins deux couches avec une couche donnant une forte magnétorésistance près de l'espaceur (par exemple une couche en CoFeB d'épaisseur 1 nm à 3nm dans le cas d'un espaceur en MgO) et une couche à plus faible constante d'échange plus éloignée de l'espaceur (par exemple une couche en NiFe dont la température de Curie est plus faible voire même un alliage NiFeX où X représente un élément non magnétique tel que Ta, Cu, Hf, Zr, Cr, V dans une proportion de l'ordre de 2 à 20% connu pour abaisser la température de Curie de l'alliage). Pour ce matériau de température de Curie réduite, il sera avantageux de choisir un matériau dont la température de Curie est typiquement de l'ordre ou inférieure à celle du Permalloy (de l'ordre de 800K) mais supérieure à la température maximale que peut atteindre le dispositif en fonctionnement, c'est-à-dire typiquement 280°C soit environ 550K. Ce choix permet de générer un vortex plus facilement déformable ce qui permet d'utiliser des champs d'écriture plus faible et d'obtenir des signaux de magnétorésistance plus importants en amplitude. Mais il est important néanmoins que la couche magnétique 2 ne devienne pas complètement paramagnétique sous l'effet d'un échauffement au cours du fonctionnement du dispositif pour ne pas perdre la configuration en vortex.

Le dispositif magnétique comporte ensuite une couche de stockage 4 séparée de la couche de référence 2 par un espaceur 3.

La déformation du vortex dans l'une des deux directions se traduit par une modification de l'aimantation moyenne, et par conséquent par une modification de résistance à cause de l'effet magnétorésistif, soit au-travers des effets de magnétorésistance géante GMR (« Giant MagnetoResistance »), comme pour les vannes de spin, ou des effets de magnétorésistance tunnel TMR (« Tunnel MagnetoResistance »), comme pour les jonctions tunnel magnétiques JTM.

L'espaceur 3 peut être une barrière tunnel, préférentiellement en oxyde de magnésium MgO ; de façon plus générale, la barrière tunnel peut être réalisée dans un groupe comprenant les oxydes d'aluminium $AlO_x$, de titane $TiO_x$ ou $SrTiO_3$, d'oxyde d'Hafnium et l'oxyde de magnésium MgO. On obtient alors une variation d'amplitude de la magnétorésistance comprise entre 100 et 600% entre les configurations d'alignement parallèle et antiparallèle d'aimantation. Il est important de noter que lorsque la couche de référence 2 est en configuration vortex, la magnétorésistance utile n'est pas l'amplitude totale de magnétorésistance entre l'alignement parallèle et antiparallèle mais seulement une fraction de cette magnétorésistance donnée par l'intégrale sur la surface du pilier des produits scalaires des aimantations locales des couches de référence 2 et de stockage 4 en regard à travers l'espaceur 3. Ainsi, la magnétorésistance utile peut être fortement réduite par rapport à l'amplitude totale de magnétorésistance (par exemple n'être que de 20 à 120% alors que la magnétorésistance totale entre alignement parallèle et antiparallèle est de 100 à 600%). Cette fraction de magnétorésistance sera d'autant plus importante que le vortex de la couche de référence 2 sera facilement déformable sous champ.

Selon un mode de réalisation préférentielle de l'invention, l'espaceur 3 peut être réalisé sous la forme d'une couche isolante (par exemple une couche d'oxyde isolante en Alumine d'épaisseur typique 1.5 à 3nm) comportant en son centre un contact conducteur (par exemple un pont métallique en cuivre de diamètre 10 à 30nm). Comme le courant est dans ce cas concentré au centre du pilier à l'endroit où se situe le pont conducteur, lorsque le cœur de vortex se déplace, on obtient alors une amplitude de variation de la magnétorésistance représentant une plus grande fraction de l'amplitude de magnétorésistance entre les alignements parfaitement parallèle et antiparallèle des aimantations comparativement à la situation sans pont métallique. Par exemple, si l'amplitude de magnétorésistance tunnel entre alignement parallèle et antiparallèle est comprise entre 100% et 600%, l'amplitude de magnétorésistance que l'on peut obtenir avec la configuration vortex en présence d'un pont métallique au centre du pilier peut être de 90 à 560%. En effet, en plaçant la zone conductrice au centre, la déformation du vortex permet de faire passer la couche de référence d'une aimantation moyenne quasi-nulle (vortex symétrique) à une aimantation dont la direction sera plus fortement marquée au centre de la couche de référence (dans la direction Ox ou -Ox selon que la direction du champ Hx) ; c'est précisément cette aimantation fortement marquée au centre de la couche de référence qui permet d'obtenir une très forte variation d'amplitude de la magnétorésistance entre l'état non déformé du vortex de la couche de référence 2 et l'état déformé du vortex. Pour obtenir cet effet sur l'amplitude, il convient toutefois que le cœur de vortex (cf. référence V figures 5a à 5c) soit excentrée par rapport au centre CV de la couche de référence 2 d'une distance T supérieure au rayon du cœur de vortex V (c'est-à-dire au rayon de la partie du vortex dont l'aimantation sort sensiblement du plan de la couche de référence 2).

Alternativement, l'espaceur 3 peut être constitué d'un semiconducteur ou d'un métal.

On peut également réaliser l'espaceur 3 dans une couche métal/oxyde hétérogène comme une couche à chemins de courant confiné constituée d'une barrière isolante par exemple en Alumine d'épaisseur 2 nm percée de canaux conducteurs qui sont par exemple en cuivre de diamètre nanométrique, typiquement entre 1 et 4nm.

La couche de stockage 4 est une couche magnétique qui présente une direction d'aimantation variable. Cette couche de stockage 4 peut être une monocouche magnétique ou un empilement de couches. La couche de stockage 4 peut par exemple être constituée d'un empilement de couches comportant :

- une couche constituée d'un matériau ferromagnétique présentant une structure cristallographie cubique face centrée au contact de la couche antiferromagnétique de piégeage 5 ;
- une couche de transition amorphe ou quasi-amorphe au contact de la couche ferromagnétique présentant une structure cristallographie cubique face centrée ;
- une couche ferromagnétique de structure cristallographique cubique centrée au contact de l'espaceur 3.

Dans l'exemple de la figure 3, la couche de stockage 4 est par exemple une multicouche de type (couche ferromagnétique CoFeB sur 1.5nm / couche amorphe en Ta sur 0.3nm / couche en NiFe sur 2nm).

Ce type de couche de stockage est particulièrement intéressant dans le cas où l'espaceur 4 est une barrière tunnel à base de MgO dont la structure cristallographique est cubique centrée.

Comme pour la couche de référence, on cherche à obtenir une déformation du vortex assez aisée pour la couche de stockage, c'est-à-dire ne nécessitant pas des intensités de champ trop importantes.

On choisira donc préférentiellement des matériaux pour lesquels la constante d'échange n'est pas trop grande c'est-à-dire une température de Curie pas trop élevée. Pour cela, il est intéressant d'utiliser une couche de stockage composite constituée d'au moins deux couches avec une couche donnant une forte magnétorésistance près de l'espaceur (par exemple une couche en CoFeB dans le cas d'un espaceur en MgO) et une couche à plus faible constante d'échange plus éloignée de l'espaceur (par exemple une couche en NiFe dont la température de Curie est plus faible).

Bien entendu les caractéristiques de la couche de stockage ne sont données ici qu'à titre indicatif, et l'homme du métier saurait adapter l'invention à d'autres types de couches de stockage.

Le dispositif magnétique comporte ensuite, au contact de la couche de stockage 4, une couche antiferromagnétique synthétique 5 qui permet de piéger la direction d'aimantation de la couche de stockage 4 en standby et lors de la lecture (c'est-à-dire à tout moment hormis pendant l'écriture proprement dite), et qui permet la libération de la direction d'aimantation de la couche de stockage 4 lors de l'écriture. La couche antiferromagnétique 5 présente de préférence une température de blocage à l'échelle de temps de l'écriture suffisamment élevée pour qu'en l'absence de chauffage, la couche antiferromagnétique 5 piège la direction d'aimantation de la couche de stockage 4. Cette échelle de temps de l'écriture correspond à la durée caractéristique de l'événement d'écriture, typiquement donnée par la durée pendant laquelle l'élément mémoire est chauffé pendant l'écriture. Dans les applications MRAMs, cette échelle de temps est typiquement de l'ordre de 5 à 20ns. Il est connu par ailleurs que plus l'échelle de temps du chauffage est courte, plus la température de blocage de la couche antiferromagnétique à l'échelle de temps considérée tend vers la température de Néel du matériau antiferromagnétique. Toutefois, cette température de blocage à l'échelle de temps de l'écriture ne doit pas être trop élevée pour qu'il ne soit pas trop difficile de libérer la direction d'aimantation de la couche de stockage 4. Ainsi, la couche antiferromagnétique 5 présente de préférence une température de blocage à l'échelle de temps de l'écriture comprise entre 200 et 300°C. La couche antiferromagnétique 5 peut par exemple être réalisée en alliage iridium-manganèse en particulier de composition atomique proche de Ir20Mn80, fer-manganèse en particulier de composition atomique proche de Fe50Mn50, nickel-manganèse en particulier de composition atomique proche de Ni50Mn50 ou en alliage iridium-manganèse-chrome avec un pourcentage atomique de chrome compris entre 10 et 25%.

La couche de stockage 4 peut être une couche dans une configuration magnétique monodomaine ou être, comme la couche de référence 2, dans une configuration vortex ; la configuration vortex de la couche de stockage 4 permet de manière particulièrement avantageuse, de réaliser un nombre de niveaux de stockage strictement supérieur à deux dans un seul point mémoire (i.e. stocker plus de deux informations « 0 » ou « 1 » dans un seul point mémoire) ; nous reviendrons plus en détails sur cet avantage dans la suite de la description.

Comme pour la couche de référence 2, il conviendra de choisir l'épaisseur de la couche de stockage 4 (pour un rayon donné) de manière appropriée de sorte qu'elle soit dans une configuration monodomaine stable ou dans un état vortex stable (cf. figure 2).

Les différentes couches formant le point mémoire 1 sont préférentiellement de forme sensiblement circulaire de sorte que le point mémoire ait une forme sensiblement cylindrique. Cette forme cylindrique ne pose pas de problème particulier quant à la stabilité thermique de la couche de stockage 4 qui est ici assurée par l'interaction à travers l'interface avec la couche antiferromagnétique 5.

Cette forme cylindrique est également avantageuse du point de vue énergétique pour faire commuter l'aimantation de la couche de stockage 4 au moment de l'écriture, une fois que la couche antiferromagnétique de piégeage 5 est proche de sa température de Néel. La forme cylindrique favorise en outre la formation de l'état vortex dans la couche de référence 2.

Il convient de noter que l'on peut piéger un état vortex déformé suite à l'application d'un champ dans une couche antiferromagnétique de piégeage. Ceci a été par exemple montré dans l'article « Imprinting vortices into Antiferromagnets » (J.Sort, G.Salazar-Alvarez and M.D.Baro, B.Dieny, A.Hoffmann and V.Novosad, J. Nogues, K.S. Buchanan, A. Bollero, Phys. Rev. Lett 97 (2006) 067201).

La couche antiferromagnétique synthétique 5 permet de piéger le vortex déformé de la couche de stockage 4 lors de la lecture, et permet la libération de la configuration vortex de la couche de stockage 4 lors de l'écriture. La couche antiferromagnétique 5 présente de préférence une température de blocage à l'échelle de temps de l'écriture suffisamment élevée pour qu'en l'absence de chauffage, la couche antiferromagnétique 5 piège la direction d'aimantation de la couche de stockage 4.

Après avoir effectué le refroidissement sous champ, le cœur de vortex de la couche de stockage 4 se trouve donc décentré dans l'état rémanent.

Comme évoqué plus haut, le dispositif magnétique selon l'invention comporte avantageusement plusieurs points mémoire comportant chacun une couche de référence à l'état vortex et une couche de stockage à écriture assistée thermiquement (préférentiellement également à l'état vortex) séparées l'une de l'autre par un espaceur.

De manière avantageuse, pour que le dispositif selon l'invention fonctionne à l'échelle d'un ensemble de points mémoire, il est préférable que tous les vortex des couches de référence (et le cas échéant des couches de stockage) aient la même chiralité (c'est à dire le même sens de rotation qui peut être horaire ou antihoraire en prenant comme référence l'aimantation du cœur de vortex pointant vers le haut de la couche).

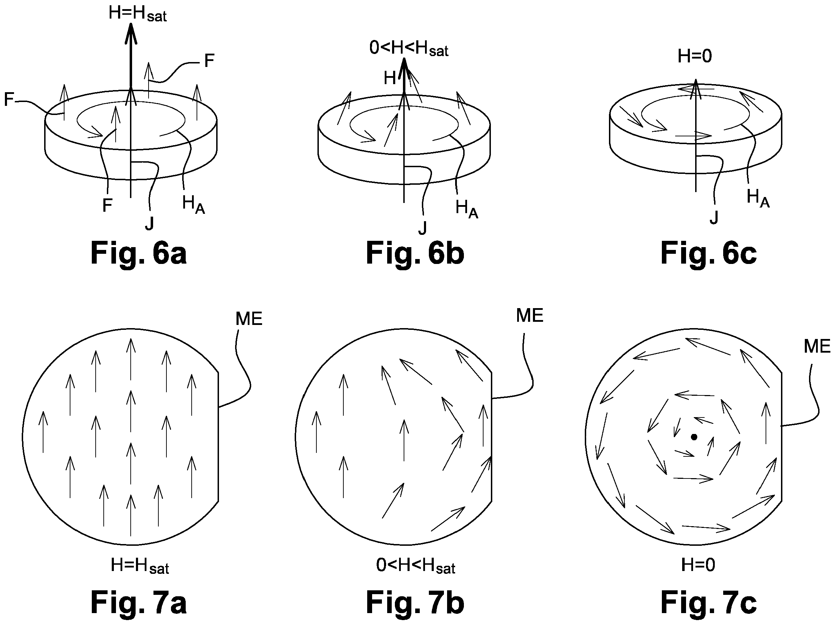

Un mode de réalisation de cette phase d'initialisation est illustré sur les figures 6a à 6c.

Pour initialiser ces vortex avec tous la même chiralité, on peut appliquer un champ H hors du plan de module décroissant progressivement depuis la saturation (H=Hsat tel que représenté en figure 6a) hors du plan jusqu'à zéro (H=0 tel que représenté en figure 6c). Ce champ H est combiné avec un champ magnétique ampérien $H_A$ créé par un courant J traversant chaque empilement magnétorésistif formant un point mémoire ; le courant J est injecté perpendiculairement aux couches formant ledit point. L'aimantation locale sur la couche de référence est représentée par les flèches F. Le champ ampérien créé par le courant J a une symétrie de révolution comme indiqué sur les figures 6a-c par la flèche $H_A$. Cette symétrie de révolution est apte à favoriser la formation d'un état vortex de l'aimantation de la couche magnétique dont la chiralité est déterminée par le sens du courant traversant l'élément. Lors de l'application du champ de saturation hors du plan, l'aimantation est globalement hors du plan. En diminuant progressivement le champ H, l'aimantation locale retombe progressivement dans le plan de la couche tout en s'alignant sur le champ ampérien $H_A$, l'aimantation du cœur de vortex restant dirigée suivant la direction du champ à saturation Hsat. Cette évolution progressive de l'aimantation de la saturation hors du plan pour H=Hsat à la configuration vortex pour H=0 en passant par tous les champs intermédiaires entre Hsat et 0 est représentée sur les figures 6a,b,c.

Grace au champ H hors du plan qui permet de réduire la barrière d'énergie séparant les deux états vortex de chiralité opposée, même un faible champ ampérien suffit à définir la chiralité du vortex. Ce procédé d'initialisation est appliqué sur chacun des points mémoire de sorte que chaque couche de référence (et le cas échéant chaque couche de stockage) à l'état vortex possède la même chiralité.

Une autre méthode pour imposer une même chiralité à tous les vortex consiste à donner aux éléments magnétorésistifs ou en tout cas aux couches magnétiques que l'on veut mettre en configuration vortex une forme quasi-cylindrique comprenant un léger méplat (cf. méplat ME sur les figures 7a à 7c) ou une légère asymétrie de rotation par exemple une forme de demi disque accolée à une demi-ellipse présentant un léger rapport de forme (par exemple entre 1.1 et 1.3), le grand axe de la demi-ellipse étant accolé au diamètre du demi-disque. En appliquant un champ saturant dans le plan parallèlement au méplat ou au grand axe de l'ellipse puis en diminuant graduellement ce champ à 0, on crée un état vortex dont la chiralité est déterminée par le fait que l'aimantation le long du méplat ou du côté de la partie elliptique de la structure est sensiblement orientée selon le champ saturant initialement appliqué dans le plan. Ceci est illustré schématiquement sur les figures 7a (application d'un champ de saturation parallèle au méplat ME), 7b (diminution du champ de saturation), 7c (annulation du champ de saturation et création d'un état vortex d'une chiralité contrôlée).

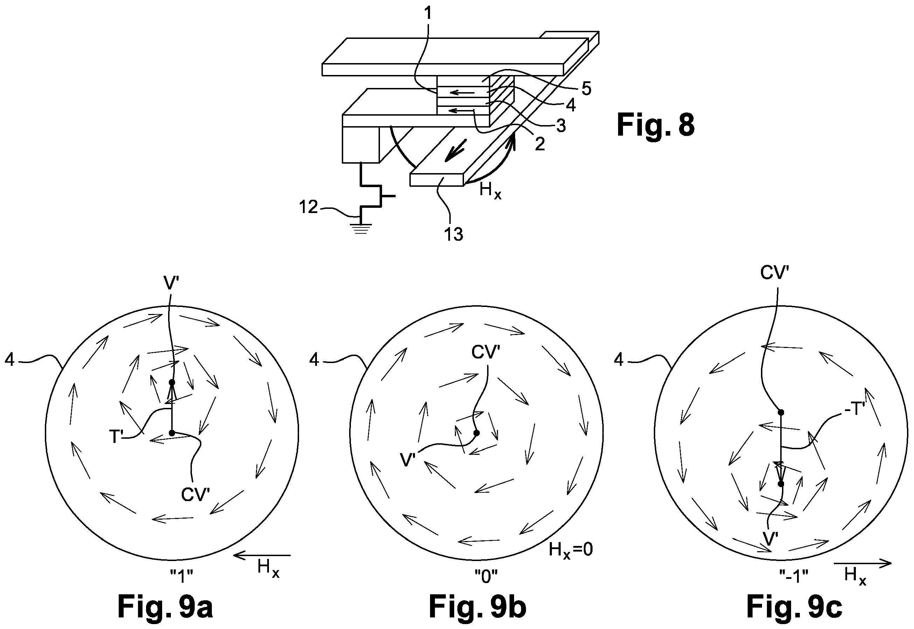

La figure 8 représente schématiquement les moyens d'écriture du dispositif 1 de la figure 3 selon un premier mode de réalisation de l'invention.

Pour permettre l'écriture d'une information dans la couche de stockage 4, le dispositif magnétique 1 comporte un transistor 12 qui est conducteur en mode écriture. En outre, le dispositif magnétique 1 comporte une ligne conductrice 13 située au-dessous de l'empilement magnétique. Cette ligne conductrice 13 est agencée de façon à ce que, lorsqu'elle est traversée par un courant électrique, elle crée un champ magnétique Hx au niveau de la couche de stockage qui va permettre d'écrire l'information de la couche de stockage 4. A l'écriture, le transistor 12 est en mode passant de sorte qu'un courant peut circuler à travers l'empilement provoquant un échauffement de la couche de stockage 4 et de la couche antiferromagnétique 5 par effet Joule. Cet échauffement atteint une température supérieure ou égale à la température de blocage de la couche antiferromagnétique 5 à l'échelle de temps de l'écriture. On notera qu'en mode écriture, il convient de chauffer la couche antiferromagnétique 5 à une température dite de blocage (qui peut être inférieure à la température de Néel) de sorte que la direction d'aimantation de la couche de stockage 4 ne soit plus piégée. Comme l'effet de dépiégeage de l'aimantation de la couche de stockage sous l'effet du chauffage est un effet thermiquement activé, la température de blocage dépend de la durée du pulse de chauffage. C'est pour cela qu'il est précisé que la température de blocage considérée est celle à l'échelle de temps de l'écriture.

Simultanément, le champ magnétique Hx est créé par le premier conducteur 13. Ce champ magnétique Hx agit sur la couche de stockage 4, cette dernière n'étant plus piégée ; l'action du champ Hx, dans le cas d'une couche de stockage 4 dans une configuration initiale à l'état vortex, est illustré sur les figures 9a à 9c.

Si on désigne par Hs' le champ d'annihilation du vortex de la couche de stockage 4, lorsque la composante du champ Hx située au-dessus de la couche de stockage est négative et supérieur à -Hs (c'est-à-dire un champ appliqué suivant la direction -Ox et de norme inférieure à Hs' - figure 8a), le cœur de vortex V' se déplace transversalement par rapport au champ appliqué suivant la direction Oy. En d'autres termes, le cœur de vortex V est translaté d'un vecteur T' par rapport au centre CV' de la couche de stockage 4. Le cœur de vortex V se déplace de façon à favoriser l'orientation de l'aimantation moyenne du vortex selon la direction du champ Hx (i.e. ici la zone basse du vortex dans laquelle l'aimantation est préférentiellement dirigée suivant le champ Hx est agrandie).

Pour un champ Hx positif et inférieur au champ d'annihilation Hs' (c'est-à-dire un champ appliqué suivant la direction Ox et de norme inférieure à Hs' - figure 9c), le cœur de vortex CV se déplace transversalement par rapport au champ appliqué suivant la direction -Oy. En d'autres termes, le cœur de vortex V est translaté d'un vecteur -T' par rapport au centre CV' de la couche de stockage 4. A nouveau, le cœur de vortex V se déplace de façon à favoriser l'orientation de l'aimantation moyenne du vortex selon la direction du champ Hx (i.e. ici la zone haute du vortex dans laquelle l'aimantation est préférentiellement dirigée suivant le champ Hx est agrandie).

L'aimantation moyenne de la configuration magnétique non déformée (figure 9b) est quasi nulle du fait de sa symétrie cylindrique.

La déformation du vortex dans l'une des deux directions se traduit par une modification de l'aimantation moyenne suivant -Ox ou +Ox.

On constate donc qu'au moyen d'un champ magnétique Hx, on peut obtenir trois états différents du vortex de la couche de stockage :

- un premier état non déformé (figure 9b) correspond à un état « 0 » ;
- un second état déformé (figure 9a) correspondant à un état « 1 » ;
- un troisième état déformé (figure 9c) correspondant à un état « -1 ».

En d'autres termes, il est possible d'imprimer dans la couche de stockage 4 plus de deux états possibles d'information (i.e. telles que les aimantations parallèles ou antiparallèles connues dans les dispositifs magnétiques), le dispositif 1 selon l'invention étant ici susceptible de stocker trois niveaux (ou états) d'information.

Une fois que la direction d'aimantation de la couche de stockage 4 a été placée dans l'état voulu, on coupe le courant qui traverse l'empilement pour permettre à l'empilement de se refroidir en présence du champ magnétique puis on coupe le courant dans le conducteur 13 pour supprimer le champ appliqué. La couche antiferromagnétique 5 étant redevenue antiferromagnétique, elle piège la direction locale d'aimantation de la couche de stockage 4 dans une configuration de vortex centré ou décentré proche de celle présente lors du refroidissement de la couche de stockage sous champ. Cette configuration n'est pas exactement la même que celle pendant le refroidissement car elle résulte d'un équilibre énergétique entre le couplage interfacial avec la couche antiferromagnétique, l'énergie d'échange et l'énergie magnétostatique du système. Plus le couplage interfacial entre la couche ferromagnétique de stockage et la couche antiferromagnétique adjacente est grand par rapport à l'influence des autres termes d'énergie, plus la configuration piégée sera proche de celle présente pendant le refroidissement sous champ.

Ensuite, pour lire l'information contenue dans la couche de stockage 4, on peut effectuer soit une lecture différentielle séquentielle soit une lecture dynamique grâce à la couche de référence 3.

Selon une approche différentielle séquentielle, on compare le niveau de résistance de l'empilement magnétorésistif formé par le dispositif magnétique pour deux orientations différentes de la direction d'aimantation résultante (c'est-à-dire moyennée sur toute la surface de la couche de référence) de la couche de référence 3. Pour cela, on oriente, avec un premier champ magnétique produit par un premier courant dans le conducteur 13, la direction d'aimantation de la couche de référence 3 dans un premier sens prédéterminé ; en d'autres termes, on déforme le vortex de la couche de référence 3 dans une direction prédéterminée (par exemple telle que représentée sur la figure 5a). On mesure alors la résistance R1 du dispositif magnétique à l'aide d'un courant de lecture plus faible, typiquement divisé par un facteur 2, que le courant de chauffage utilisé au moment de l'écriture. On applique ensuite un deuxième champ magnétique généré par un deuxième courant dans le conducteur 13 de direction opposée au premier courant, de façon à orienter la direction d'aimantation de la couche de référence 3 dans le sens opposé au premier sens prédéterminé (i.e. déformation du vortex telle que représentée sur la figure 5c). On mesure alors à nouveau la résistance R2 du dispositif magnétique. Après chaque courant, on connaît la direction moyenne privilégiée d'aimantation de la couche de référence 3, puisqu'on connaît la direction des champs magnétiques appliqués. Par conséquent, en comparant la résistance du dispositif magnétique avec le premier courant et avec le deuxième courant, on en déduit la direction d'aimantation de la couche de stockage 4, et donc l'information contenue dans la couche de stockage 4.

- Si R1<R2, alors l'aimantation de la couche de stockage (ou sa résultante moyenne si la couche de stockage est elle-même en vortex avec écriture assistée thermiquement) est orientée dans la direction correspondant à la première direction prédéterminée ;
- Si R1>R2, alors l'aimantation de la couche de stockage (ou sa résultante moyenne si la couche de stockage est elle-même en vortex avec écriture assistée thermiquement) est orientée dans la direction opposée à la première direction prédéterminée.

Comme discuté précédemment, le dispositif magnétique selon l'invention permet de discriminer plus de deux niveaux dans le cas d'une utilisation de la couche de stockage à l'état vortex ; ainsi, en plus des configurations notées « 1 » et « -1 » des figures 9a et 9c, il est possible d'avoir un niveau d'information « 0 » correspondant à celui de la figure 9b de vortex non déformé ; le procédé de lecture d'un tel dispositif se fait de manière identique à celui précédemment décrit selon l'approche différentielle séquentielle ; on obtient donc deux valeurs de résistances R1 et R2. La procédure pour discriminer les trois états « 0 », « 1 » ou « -1 » est alors la suivante ; trois conditions vont être possibles ici :

- Si 0<r<R2-R1, alors la résultante moyenne de l'aimantation de la couche de stockage est orientée dans la direction correspondant à la première direction prédéterminée (état « 1 », l'aimantation moyenne de la couche de stockage pointe vers la gauche comme sur la figure 9a et sur la figure 8) ;
- Si abs(R1-R2)<r où « abs » désigne la fonction « valeur absolue », alors la résultante moyenne de l'aimantation de la couche de stockage est quasi nulle (état « 0 », le vortex de la couche de stockage n'est pas déformé comme sur la figure 9b) ; on notera que cette résultante n'est jamais totalement nulle dans la mesure où le vortex n'est jamais totalement symétrique ;

• Si 0<r<R1 -R2, alors la résultante moyenne de l'aimantation de la couche de stockage est orientée dans la direction correspondant à la deuxième direction prédéterminée (état « -1 », l'aimantation moyenne de la couche de stockage pointe vers la droite comme sur la figure 9c)

Ici, r est un seuil de résistance très inférieur à la différence des résistances R1 et R2 défini par exemple comme r=1/10*abs(R1-R2) ; cette valeur seuil r prend en compte le fait que le vortex de la couche de stockage peut ne pas être parfaitement symétrique (cas où r serait égal à 0). De ce fait, la condition mathématique R1=R2 qu'on aurait pour un vortex exactement centré et un déplacement parfaitement symétrique du vortex de la couche de lecture dans les deux étapes de la lecture séquentielle n'est possible qu'à une incertitude r près.

Pour toutes les réalisations de stockage multiniveaux (i.e. stockage d'un nombre d'états strictement supérieur à 2 au sein d'un même point mémoire), il est préférable que la distribution de courant circulant à travers l'ensemble de l'espaceur ait une symétrie proche de circulaire de sorte qu'une position du cœur de vortex dans la couche de stockage puisse sans ambiguïté être associée à une valeur de résistance de l'élément magnétorésistif. Ceci est réalisé si l'espaceur est constitué d'une couche de conductivité latérale aussi homogène que possible ; en d'autres termes, l'espaceur sera préférentiellement soit une barrière tunnel soit un espaceur métallique ; l'espaceur peut également être constitué d'une couche isolante traversée en son centre par un pont conducteur. En revanche, selon ce mode de réalisation, l'espaceur sera plus difficilement constitué d'une couche à chemins de courant confiné c'est-à-dire d'une couche isolante percée de ponts conducteurs aléatoirement répartis sur sa surface.

Comme mentionné plus haut, pour lire l'information contenue dans la couche de stockage 4, on peut également effectuer une lecture dynamique.

Ainsi, pour améliorer la vitesse de lecture du dispositif magnétique, on peut lire l'information contenue dans la couche de stockage de manière dynamique. Pour cela, on envoie un pulse de courant à travers la ligne conductrice 13, ce pulse de courant créant un pulse de champ magnétique au niveau de la couche de référence 2. Le pulse de champ provoque une oscillation du cœur de vortex de la couche de référence 2 qui génère une oscillation de tension aux bornes de l'élément magnétorésistif (empilement formé par les couches 2, 3 et 4) lorsque celui-ci est parcouru par un courant J (ouverture du transistor 12).

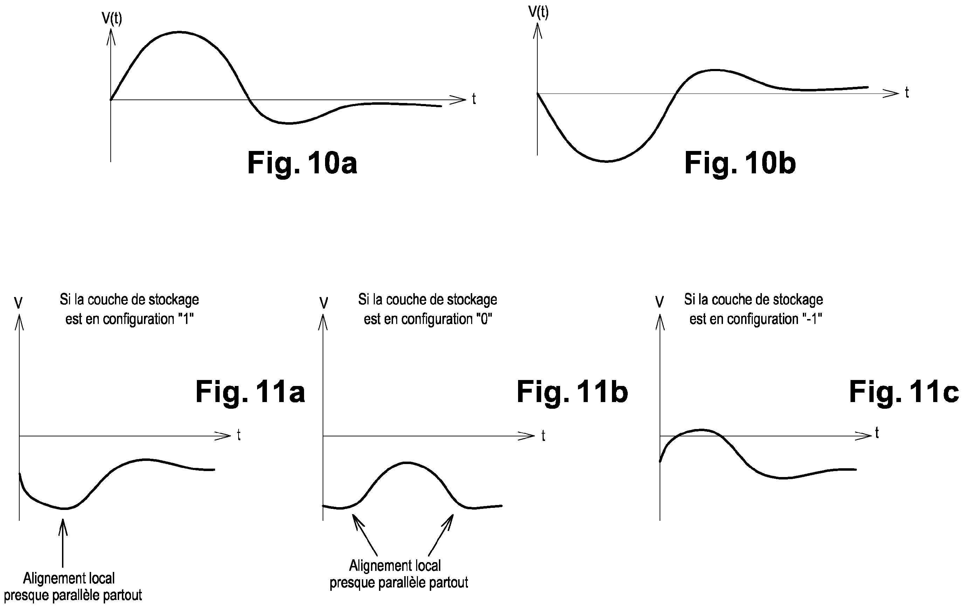

Le pulse de tension ainsi créé peut présenter un pic de tension qui est soit positif (figure 10a), soit négatif (figure 10b), suivant que les résultantes d'aimantation des couches de stockage et de référence sont parallèles ou antiparallèles. Le signe de ce pic de tension permet donc de connaître la direction d'aimantation de la couche de stockage plus rapidement.

Pour l'orientation de Hx indiquée sur la figure 8, le pulse de tension sera comme illustré en figure 10b (baisse de tension au moment du pulse de champ) si l'aimantation de la couche de stockage pointe vers la gauche (i.e. sa résultante d'aimantation est sensiblement parallèle à la résultante d'aimantation de la couche de référence au moment du pulse de champ).

Pour l'orientation de Hx indiquée sur la figure 8, le pulse de tension sera comme illustré en figure 10a (augmentation de tension au moment du pulse de champ) si l'aimantation de la couche de stockage pointe vers la droite (i.e. sa résultante d'aimantation est sensiblement antiparallèle à la résultante d'aimantation de la couche de référence au moment du pulse de champ).

Un système intégrateur, par exemple, permettra alors de déterminer l'orientation de la couche de stockage à partir du signe du signal moyen de tension consécutif au pulse de champ.

Comme précédemment, on peut également lire de manière dynamique le dispositif magnétique selon l'invention lorsque la couche de stockage de ce dernier est dans une configuration vortex multiniveaux, par exemple trois niveaux « 0 », « 1 » et « -1 » tels que représentés sur les figures 9a à 9c.

Pour ce faire, le principe est très proche de la lecture dynamique à deux niveaux. On envoie un pulse de courant dans la ligne conductrice de bit 13 générant un pulse de champ magnétique et on suit en dynamique l'évolution de la tension aux bornes de l'empilement magnétorésistif, ce dernier étant parcouru par un courant donné d'amplitude J.

Suivant l'état magnétique de la couche de stockage 4, la forme temporelle de la tension va varier ; La forme du signal de tension permet donc de connaître la direction d'aimantation de la couche de stockage plus rapidement.

Pour l'orientation de Hx indiquée sur la figure 8, celle-ci va favoriser pendant l'existence du pulse de champ, une résultante d'aimantation du vortex de la couche de référence dirigée suivant le champ Hx lorsque celui-ci est au-dessus de l'empilement magnétorésistif (i.e. une déformation du type de celle représentée en figure 6a et une résultante pointant globalement vers la gauche).

Ainsi, pour l'orientation de Hx indiquée sur la figure 8, le pulse de tension sera comme illustré en figure 11a (baisse de tension dès le début du pulse de champ) si la résultante d'aimantation de la couche de stockage pointe vers la gauche (i.e. on a un alignement local des aimantations sur la quasi-totalité des surfaces des deux couches de référence de stockage et de référence qui apparaît et qui est au maximum au moment du pulse de champ) telle qu'illustrée en figure 9a (niveau « 1 »).

Pour l'orientation de Hx indiquée sur la figure 8, le pulse de tension sera comme illustré en figure 11b (tension minimale puis augmentation de tension au moment du pulse de champ puis à nouveau tension minimale) si l'aimantation de la couche de stockage est en configuration vortex non déformé (i.e. on a avant le pulse un alignement locale des aimantations sur la quasi-totalité des surfaces des deux couches de référence de stockage et de référence puis une augmentation de la tension qui apparaît et qui est au maximum au moment du pulse de champ, puis à nouveau après la fin du pulse un alignement locale des aimantations sur la quasi-totalité des surfaces des deux couches de référence de stockage et de référence) telle qu'illustrée en figure 9b (niveau « 0 ») ; le pic de tension correspond à un augmentation de la magnétorésistance lorsque la configuration vortex de la couche de référence est déformée.

Pour l'orientation de Hx indiquée sur la figure 8, le pulse de tension sera comme illustré en figure 11c (augmentation de tension dès le début du pulse de champ) si la résultante d'aimantation de la couche de stockage pointe vers la droite (i.e. on a localement des aimantations qui sont antiparallèles sur la quasi-totalité des surfaces des deux couches de référence de stockage et de référence au moment du pulse de champ) telle qu'illustrée en figure 9c (niveau « -1 »).

L'analyse de la réponse impulsionnelle de tension permet donc de discriminer entre les différents états de la couche de stockage.

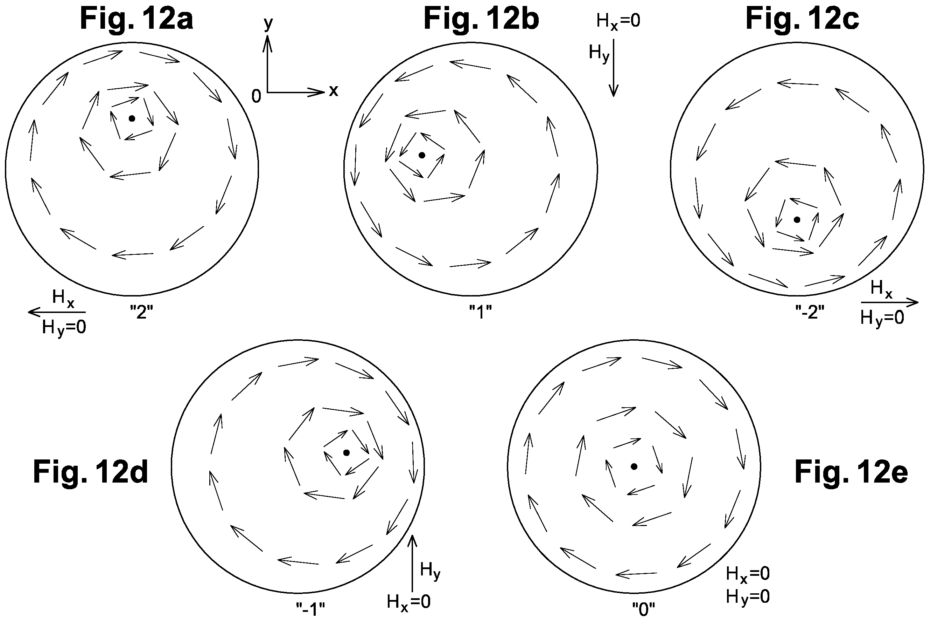

Comme évoqué précédemment, la configuration vortex de la couche de stockage 4 permet de manière particulièrement avantageuse, de réaliser un nombre de niveaux de stockage strictement supérieur à deux dans un seul point mémoire (i.e. stocker plus de deux états d'information « 0 » ou « 1 » dans un seul point mémoire) ; nous avons démontré que cette couche pouvait stocker trois niveaux de stockage en utilisant une composante de champ Hx et un déplacement du cœur de vortex transverse à la direction de ce champ. On comprend dès lors qu'en utilisant deux composantes de champ ayant des directions différentes, notamment perpendiculaires, on peut augmenter davantage le nombre de niveaux de stockage au sein de la couche de stockage 4 initialement dans l'état vortex non déformé. Les figures 12a à 12e illustrent ce principe dans le cas de deux composantes de champ Hx et Hy respectivement suivant les directions Ox et Oy perpendiculaires ; chaque composante Hx peut pointer suivant la direction Ox ou - Ox et chaque composante Hy peut pointer suivant la direction Oy ou -Oy.

On constate donc qu'au moyen des deux composantes de champ magnétique Hx et Hy on peut obtenir cinq états différents du vortex de la couche de stockage :

- un premier état non déformé illustré en figure 12e (correspondant à la figure 9b) définissant un état « 0 » pour des composantes Hx et Hy nulles ;
- un second état déformé vers le haut illustré en figure 12a (correspondant à la figure 9a) définissant un état « 2» pour une composante Hx pointant vers -Ox et une composante Hy nulle ;
- un troisième état déformé vers le bas illustré en figure 12c (correspondant à la figure 9c) définissant un état « -2» pour une composante Hx pointant vers Ox et une composante Hy nulle ;

- un quatrième état déformé vers la gauche illustré en figure 12b définissant un état « 1 » pour une composante Hy pointant vers -Oy et une composante Hx nulle ;
- un cinquième état déformé vers la droite illustré en figure 12d définissant un état « -1 » pour une composante Hy pointant vers Oy et une composante Hx nulle.

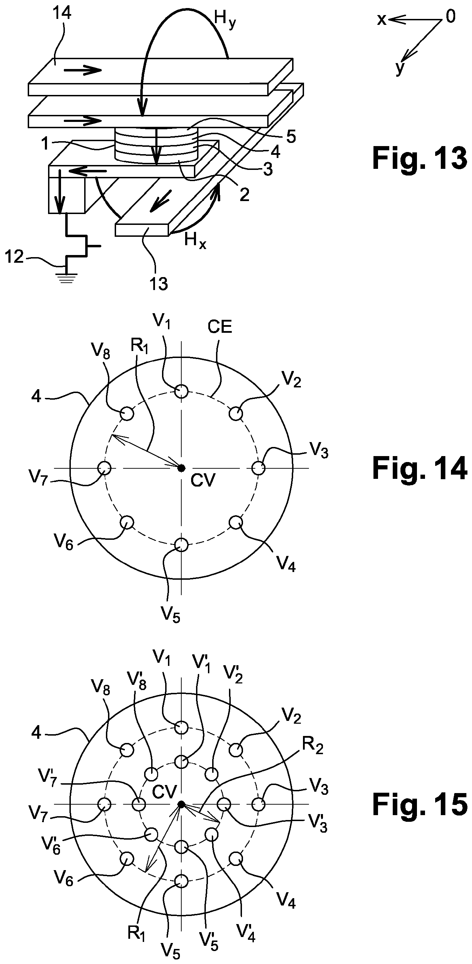

Les moyens d'écriture/lecture de ces différents états sont illustrés en figure 13 selon un second mode de réalisation de l'invention.

Le dispositif 1 est identique à celui décrit en référence à la figure 3 mais pour écrire les différents états illustrés aux figures 12a à 12e, on rajoute deux lignes conductrices 13 (identique à la ligne 13 telle qu'illustrée en figure 8) et 14 orthogonales pour créer deux composantes de champ magnétiques orthogonales Hx et Hy. Les lignes conductrices 13 et 14 sont préférentiellement respectivement disposées au-dessous et au-dessus des lignes permettant d'injecter un courant dans l'empilement magnétorésistif lorsque le transistor 12 est ouvert.

Pour écrire une information dans la couche de stockage 4, on envoie un courant à travers à travers l'empilement magnétorésistif, le transistor 12 étant passant. L'empilement s'échauffe alors à une température supérieure à la température de blocage de la couche antiferromagnétique 5 à l'échelle de temps de l'écriture, de sorte que la direction d'aimantation de la couche de stockage 4 n'est plus piégée.

Simultanément, on crée le couple de champ magnétique (Hx, Hy) voulu pour écrire l'un des cinq niveaux tels qu'illustrés aux figures 12a à 12e.

Le champ magnétique Hx est créé en injectant un courant dans la première ligne conductrice 13 et le champ magnétique Hy est créé en injectant un courant la seconde ligne conductrice 14 perpendiculaire à la première ligne conductrice 13.

Les champs magnétiques Hx et Hy agissent sur la couche de stockage 4 respectivement dans les directions Ox et Oy, cette dernière n'étant plus piégée ; l'action des champs Hx et Hy, dans le cas d'une couche de stockage 4 dans une configuration initiale à l'état vortex, est illustrée sur les figures 12a à 12e.

Une fois que la direction d'aimantation résultante de la couche de stockage 4 a été placée dans l'état voulu, on coupe le courant qui traverse l'empilement pour permettre à l'empilement de se refroidir en présence du champ magnétique puis on coupe le courant dans le conducteur 13 ou dans le conducteur 14 pour supprimer le champ appliqué. La couche antiferromagnétique 5 étant redevenue antiferromagnétique, elle piège la configuration d'aimantation de la couche de stockage 4 dans un état proche de celui dans laquelle elle se trouvait pendant le refroidissement sous champ. Comme expliqué précédemment, la configuration piégée correspond à un équilibre entre énergie interfaciale de couplage entre la couche ferromagnétique et antiferromagnétique (énergie communément appelée d'anisotropie d'échange), énergie d'échange et magnétostatique. Seulement lorsque l'énergie de couplage interfaciale est très grande par rapport à l'influence des autres termes d'énergie, la configuration piégée en champ nul et à température ambiante correspond à la configuration sous champ pendant le refroidissement. Si l'énergie de couplage n'est pas beaucoup plus forte que les autres termes d'énergie, alors la configuration sera intermédiaire entre la configuration présente lors du refroidissement sous champ et la configuration de vortex centré.

La lecture de l'une des 5 configurations stockées dans la couche de stockage 4 peut se faire de façon séquentielle en mettant la couche de référence 2 successivement dans les 5 configurations possibles similaires à celles décrites pour la couche de stockage. Pour ce faire, on applique la composante de champ Hx ou Hy pour mettre la couche de référence 2 dans la configuration souhaitée et on injecte un courant de lecture plus faible, typiquement divisé par un facteur 2, que le courant de chauffage utilisé au moment de l'écriture.

Dans chacune des configurations, on mesure la résistance de l'empilement magnétorésistif. La configuration de la couche de référence 2 donnant la plus faible résistance (parmi les cinq résistances obtenues) correspond à celle qui est stockée dans la couche de stockage 4.

On comprend que la précision du dispositif sera encore plus efficace si on fait en sorte que la couche de référence et la couche de stockage soient identiques, c'est-à-dire qu'elles soient toutes les deux des couches ayant une configuration à l'état vortex, avec une même épaisseur et réalisées dans le même matériau (la seule différence résidant dans le fait que la couche de stockage est couplée à une couche de piégeage antiferromagnétique alors que la couche de référence n'est pas piégée) ; en d'autres termes, au-dessus de la température de blocage de la couche de piégeage antiferromagnétique, les aimantations des deux couches de référence et de stockage réagissent de la même façon au champ magnétique appliqué.

On peut aussi discriminer l'un des 5 niveaux stocké de façon dynamique en appliquant successivement deux pulses de champ orthogonaux.

Pour l'un de ses puises, le cœur de vortex de la couche de référence va osciller dans la direction parallèle au décentrage du cœur de vortex de la couche de stockage. Au contraire, pour l'autre pulse, le cœur de vortex va osciller transversalement au décentrage du cœur de vortex de la couche de stockage. Dans le premier cas (oscillation suivant le décentrage), les oscillations de tension vont être très similaires à celles décrites pour la lecture à 3 niveaux telle que décrite en référence aux figures 11a à 11c. Au contraire, pour l'autre impulsion, il n'y aura quasiment pas de variation de tension liée à l'impulsion. De plus, si la couche de stockage est à l'état "0" (i.e. quasiment sans décentrage), alors les deux impulsions de champ vont donner la même forme de réponse de tension (typiquement celle représentée en figure 11b). Ainsi en combinant les informations des deux impulsions de champ, on peut connaître sans ambiguïté l'état magnétique de la couche de stockage.

Une autre façon de procéder pour la lecture consiste à générer sur l'élément magnétorésistif et particulièrement au niveau de la couche de référence un champ tournant de module constant de l'ordre du champ d'écriture grâce à des courants sinusoïdaux et quadrature circulant dans les lignes conductrices 13 et 14 de la Figure 13. Ce champ tournant va permettre de faire tourner le cœur du vortex de la couche de référence suivant une trajectoire circulaire centrée sur le centre de la couche de référence. Ce mouvement rotatif du cœur de vortex va générer une oscillation quasi sinusoïdale de la résistance de l'élément magnétorésistif avec un minimum de résistance obtenu quand le cœur de vortex de la couche de référence passera près du cœur de vortex de la couche de stockage. Ainsi la mesure de la phase de l'oscillation de résistance permet de connaitre la position du cœur de vortex dans la couche de stockage et ainsi l'information écrite dans la couche de stockage. Dans le cas où la couche de stockage est dans un état de vortex centré (Fig.12e), la rotation du cœur de vortex de la couche de référence ne s'accompagne d'aucun changement de résistance de l'empilement magnétorésistif ce qui permet de discriminer l'état logique « 0 » des autres états.

On peut généraliser en stockant encore davantage d'états possibles dans la couche de stockage correspondant à différents rayons de décentrage du cœur de vortex et différents angles de décentrage.

Selon le mode de réalisation précédemment décrit pour cinq niveaux stockables dans la couche de stockage, l'écriture consistait à utiliser l'une ou l'autre des composantes perpendiculaires Hx ou Hy de champ magnétique. Il est toutefois possible d'appliquer en même temps une composante Hx et Hy de champ magnétique tout en chauffant au-dessus de la température de blocage de la couche antiferromagnétique par un courant traversant l'empilement magnétorésistif. En d'autres termes, en choisissant correctement le couple de champs magnétiques (Hx, Hy), appliqués, on peut faire varier la position du cœur de vortex sur un cercle de rayon donné.

Une couche de stockage 4 à huit niveaux de stockage est par exemple illustrée en figure 14. Les différents couples de champs (Hx, Hy) sont par exemple caractérisés par une même amplitude et des directions régulièrement espacées dans le plan des couches (ici 8 directions possibles) de sorte que, lorsque l'empilement est chauffé, le cœur de vortex peut prendre huit positions différentes V1 à V8 sur un cercle CE. Ceci correspondra à 8 situations de décentrage du cœur de vortex régulièrement réparties sur le cercle CE centré sur le centre CV de la couche de stockage 4.

Cette opération peut être répétée avec une seconde amplitude (par exemple plus faible que la première amplitude) de champ d'écriture qui conduira à un décentrage du cœur de vortex moindre que précédemment. Cette opération est illustrée sur la figure 15.

Lorsque l'empilement est chauffé, le cœur de vortex peut prendre 16 positions différentes :

- huit positions V1 à V8 régulièrement réparties sur le cercle CE de rayon R1. Ceci correspondra aux 8 situations de décentrage du cœur de vortex telles que décrites en référence à la figure 14 ;
- huit positions V'1 à V'8 régulièrement réparties sur un cercle CE' de rayon R2 inférieur à R1.

On a ainsi 2*8=16 états possibles stockés dans la couche de stockage 4.

Ensuite à la lecture, dans le cas de la figure 14 comme dans le cas de la figure 15, on n'a pas d'assistance thermique de sorte que la couche de stockage n'évolue presque pas sous l'effet du champ appliqué grâce au piégeage par la couche antiferromagnétique ; en d'autres termes, on injecte un courant de lecture plus faible, typiquement divisé par un facteur 2, que le courant de chauffage utilisé au moment de l'écriture.

On applique alors la même séquence de champs tournants en 8 pas de 45° et de deux modules (ou amplitudes) différents. Ceci déplace le vortex de la couche de lecture. Lorsqu'il y a concordance entre le vortex de la couche de référence et le vortex de la couche de stockage, la résistance est minimale. On détecte ainsi l'état stocké par ce minimum de résistance.

Naturellement, l'invention n'est pas limitée aux modes de réalisation décrits en référence aux figures et des variantes peuvent être envisagées sans sortir du cadre de l'invention. En particulier, les matériaux et les épaisseurs choisis pour réaliser les couches de référence, les couches de stockage et les espaceurs ne sont donnés ici qu'à titre illustratif et d'autres matériaux ou épaisseurs pourraient être utilisés.

**Revendications**

1.  Dispositif magnétique (1) à écriture assistée thermiquement comportant au moins un élément magnétique incluant :

    - une première couche magnétique dite « couche de référence » (2) ;
    - une deuxième couche magnétique dite « couche de stockage » (4), la couche de stockage présentant une configuration d'aimantation variable ;
    - un espaceur non-magnétique (3) qui sépare la couche de référence (2) et la couche de stockage (4) et les découple magnétiquement ;
    - une couche antiferromagnétique (5) de piégeage au contact de la couche de stockage (4), cette couche antiferromagnétique étant apte à piéger la configuration d'aimantation de la couche de stockage;

- des moyens (12) de chauffage de ladite couche antiferromagnétique (5) de piégeage de sorte que, lors du chauffage, la température de ladite couche antiferromagnétique de piégeage dépasse sa température de blocage de sorte que, à chaud, la configuration d'aimantation de ladite couche de stockage (4) ne soit plus piégée ;

ledit dispositif (1) étant **caractérisé en ce que** ladite couche de référence (2) et ladite couche de stockage présentent une aimantation en configuration vortex stable et ledit dispositif (1) comporte des moyens (13, 14) de création d'un champ magnétique pour déplacer de manière réversible le cœur du vortex dans le plan de ladite couche de référence et ladite couche de stockage présente un nombre strictement supérieur à deux de niveaux de stockage, chaque niveau de stockage correspondant à une configuration d'aimantation piégée.

2. Dispositif selon la revendication précédente **caractérisé en ce que** les vortex de ladite couche de référence et de ladite couche de stockage ont la même chiralité.

3. Dispositif selon l'une des revendications précédentes **caractérisé en ce que** ladite couche de stockage présente trois niveaux de stockage.

4. Dispositif magnétique selon l'une des revendications précédentes **caractérisé en ce que** lesdits moyens de création d'un champ magnétique comportent des moyens pour créer deux composantes variables Hx et Hy de champ magnétique non parallèles, l'application simultanée de ces composantes de champ Hx et Hy étant apte à déplacer le cœur du vortex de ladite couche de stockage dans le plan de ladite couche de stockage lorsque celle-ci est non piégée, chaque couple de composantes Hx et Hy étant associé à un niveau de stockage.

5. Dispositif selon l'une des revendications précédentes **caractérisé en ce que** ladite couche de référence et ladite couche de stockage présentent une même épaisseur et sont réalisées dans le même matériau.

6. Dispositif selon l'une des revendications précédentes **caractérisé en ce qu'**il comporte une pluralité d'éléments magnétiques formant chacun un point mémoire, les vortex des couches de référence desdits points mémoire ayant tous la même chiralité.

7. Dispositif selon la revendication précédente **caractérisé en ce que**, pour un rayon donné dudit point mémoire, l'épaisseur de ladite couche de référence est choisie de sorte que ladite couche de référence présente une aimantation en configuration vortex stable.

8. Dispositif selon l'une des revendications précédentes **caractérisé en ce que** la température de Curie de ladite couche de référence est réduite sur au moins une partie de l'épaisseur de cette couche de référence à une valeur inférieure à 900K mais supérieure à 550K.

9. Dispositif selon l'une des revendications précédentes **caractérisé en ce que** ladite couche de référence comporte une première sous-couche au contact dudit espaceur et une deuxième sous-couche, la première sous-couche ayant une température de Curie supérieure à la deuxième sous-couche plus éloignée dudit espaceur.

10. Dispositif selon la revendication précédente **caractérisé en ce que** ladite couche de référence est une couche composite constituée d'au moins deux sous-couches incluant une sous-couche en CoFeB au contact de l'espaceur réalisé en MgO et une sous-couche à plus faible température de Curie plus éloignée de l'espaceur telle qu'une sous-couche en NiFe ou en alliage NiFeX où X représente un élément non magnétique tel que Ta, Cu, Hf, Zr, Cr, V dans une proportion de l'ordre de 2 à 20%.

11. Dispositif selon l'une des revendications précédentes **caractérisé en ce que** ledit espaceur est réalisé selon l'une des formes suivantes :

- ledit espaceur est une barrière tunnel ;
- ledit espaceur est réalisé sous la forme d'une couche isolante comportant un contact conducteur ;
- ledit espaceur est réalisé dans un matériau semiconducteur ou métallique ;
- ledit espaceur est une couche métal/oxyde hétérogène comme une couche à chemins de courant confiné constituée d'une barrière isolante percée de canaux conducteurs.

12. Dispositif selon la revendication 4 **caractérisé en ce que** lesdits moyens de création d'un champ magnétique sont adaptés pour déplacer ledit cœur de vortex par rapport au centre de ladite couche de référence d'une distance supérieure au rayon dudit cœur de vortex.

13. Dispositif selon l'une des revendications précédentes **caractérisé en ce que** ladite couche de stockage comporte au moins un empilement formé par:

- une couche magnétique constituée d'un matériau ferromagnétique présentant une structure cristallographique cubique face centrée au contact de ladite couche antiferromagnétique ;
- une couche de transition amorphe ou quasi-amorphe au contact de ladite couche de matériau ferromagnétique présentant une structure cristallographique cubique face centrée;
- une couche ferromagnétique présentant une structure cristallographique cubique centrée.

14. Dispositif magnétique selon la revendication 6 **caractérisé en ce que** ledit au moins un point mémoire est de forme sensiblement cylindrique.

15. Méthode de lecture de l'information contenue dans la couche de stockage d'un dispositif magnétique selon l'une des revendications précédentes, ladite couche de stockage présentant une aimantation en configuration vortex stable, ladite méthode comportant une étape d'application d'un champ tournant sur l'aimantation de la couche de référence, ledit champ tournant provoquant une oscillation de la résistance de l'empilement, et une étape de détermination de l'information écrite dans la couche de stockage à partir de la phase et de l'amplitude de ladite oscillation de résistance.

**Patentansprüche**

1. Magnetvorrichtung (1) mit wärmeunterstütztem Schreibverfahren, aufweisend mindestens ein Magnetelement, einschließend:

- eine erste Magnetschicht, bezeichnet als "Referenzschicht" (2),
- eine zweite Magnetschicht, bezeichnet als "Speicherschicht" (4), wobei die Speicherschicht eine variable Magnetisierungskonfiguration aufweist;
- einen nichtmagnetischen Abstandhalter (3), der die Referenzschicht (2) und die Speicherschicht (4) trennt und sie magnetisch entkoppelt;
- eine antiferromagnetische Pinningschicht (5) im Kontakt mit der Speicherschicht (4), wobei diese antiferromagnetische Schicht imstande ist, die Magnetisierungskonfiguration der Speicherschicht zu pinnen;
- Heizmittel (12) der antiferromagnetischen Pinningschicht (5), so dass beim Heizen die Temperatur der antiferromagnetischen Pinningschicht ihre Blockadetemperatur übersteigt, so dass warm die Magnetisierungskonfiguration der Speicherschicht (4) nicht mehr gepinnt wird,

wobei die Vorrichtung (1) **dadurch gekennzeichnet ist, dass** die Referenzschicht (2) und die Speicherschicht eine Magnetisierung in stabiler Vortexkonfiguration aufweisen und die Vorrichtung (1) Mittel (13, 14) zur Erzeugung eines Magnetfelds aufweist, um das Zentrum des Vortexes in der Ebene der Referenzschicht reversibel zu verlagern und die Speicherschicht eine Anzahl strikt größer als zwei Speicherniveaus aufweist, wobei jedes Speicherniveau einer gepinnten Magnetisierungskonfiguration entspricht.

2. Vorrichtung nach vorangehendem Anspruch, **dadurch gekennzeichnet, dass** die Vortexe der Referenzschicht und der Speicherschicht dieselbe Chiralität haben.

3. Vorrichtung nach einem der vorangehenden Ansprüche, **dadurch gekennzeichnet, dass** die Speicherschicht drei Speicherniveaus aufweist.

4. Magnetvorrichtung nach einem der vorangehenden Ansprüche, **dadurch gekennzeichnet, dass** die Mittel zur Erzeugung eines Magnetfelds Mittel aufweisen, um zwei nicht parallele variable Magnetfeldkomponenten Hx und Hy zu erzeugen, wobei die gleichzeitige Anwendung dieser Feldkomponenten Hx und Hy imstande ist, das Zentrum des Vortexes der Speicherschicht in die Ebene der Speicherschicht zu verlagern, wenn diese nicht gepinnt ist, wobei jedes Komponentenpaar Hx und Hy einem Speicherniveau zugeordnet ist.

5. Vorrichtung nach einem der vorangehenden Ansprüche, **dadurch gekennzeichnet, dass** die Referenzschicht und die Speicherschicht die gleiche Stärke aufweisen und aus demselben Material hergestellt sind.

6. Vorrichtung nach einem der vorangehenden Ansprüche, **dadurch gekennzeichnet, dass** sie eine Vielzahl von Magnetelementen umfasst, die jeweils einen Speicherpunkt bilden, wobei die Vortexe der Referenzschichten der Speicherpunkt alle die gleiche Chiralität haben.

7. Vorrichtung nach vorangehendem Anspruch, **dadurch gekennzeichnet, dass** für einen bestimmten Radius des Speicherpunkts die Stärke der Referenzschicht derart gewählt ist, dass die Referenzschicht eine Magnetisierung in stabiler Vortexkonfiguration aufweist.

8. Vorrichtung nach einem der vorangehenden Ansprüche, **dadurch gekennzeichnet, dass** die Curie-Temperatur der Referenzschicht auf mindestens einem Teil der Stärke dieser Referenzschicht auf einen Wert unter 900 K, aber über 550 K, reduziert ist.

9. Vorrichtung nach einem der vorangehenden Ansprüche, **dadurch gekennzeichnet, dass** die Referenzschicht eine erste Unterschicht im Kontakt mit dem Abstandhalter aufweist und eine zweite Unterschicht aufweist, wobei die erste Unterschicht eine höhere Curie-Temperatur als die zweite, vom Abstandhalter entferntere Unterschicht aufweist.

10. Vorrichtung nach vorangehendem Anspruch, **dadurch gekennzeichnet, dass** die Referenzschicht eine Kompositschicht ist, bestehend aus mindestens zwei Unterschichten, einschließend eine Unterschicht aus CoFeB im Kontakt mit dem Abstandhalter, hergestellt aus MgO, und eine Unterschicht mit einer niedrigeren Curie-Temperatur, die vom Abstandhalter entfernter ist, wie etwa eine Unterschicht aus NiFe oder aus NiFeX-Legierung, wobei X ein nichtmagnetisches Element darstellt wie etwa Ta, Cu, Hf, Zr, Cr, V in einem Anteil der Größenordnung von 2 bis 20 %.

11. Vorrichtung nach einem der vorangehenden Ansprüche, **dadurch gekennzeichnet, dass** der Abstandhalter gemäß einer der folgenden Formen hergestellt ist:

- der Abstandhalter ist eine Tunnelbarriere;
- der Abstandhalter ist in Form einer Isolationsschicht hergestellt, die einen leitenden Kontakt aufweist;
- der Abstandhalter ist aus einem halbleitenden oder metallischen Material hergestellt;
- der Abstandhalter ist eine heterogene Metall-/Oxidschicht wie eine Schicht mit eingeschlossenen Strompfaden, bestehend aus einer von leitenden Kanälen durchbrochen Isolationsbarriere.

12. Vorrichtung nach Anspruch 4, **dadurch gekennzeichnet, dass** die Mittel zur Erzeugung eines Magnetfelds zur Verlagerung des Vortexkerns in Bezug auf die Mitte der Referenzschicht in einem Abstand größer als der Radius des Vortexkerns geeignet sind.

13. Vorrichtung nach einem der vorangehenden Ansprüche, **dadurch gekennzeichnet, dass** die Speicherschicht mindestens einen Stapel aufweist, gebildet von:

- einer Magnetschicht, bestehend aus einem ferromagnetischen Material, aufweisend eine flächenzentrierte kubische kristallographische Struktur im Kontakt mit der antiferromagnetischen Schicht;
- eine amorphe oder quasi-amorphe Übergangsschicht im Kontakt mit der Schicht aus ferromagnetischem Material, die aufweisend eine flächenzentrierte kubische kristallographische Struktur;

- eine ferromagnetische Schicht, aufweisend eine zentrierte kubische kristallographische Struktur.

14. Magnetvorrichtung nach Anspruch 6, **dadurch gekennzeichnet, dass** mindestens ein Speicherpunkt etwa zylindrischer Form ist.

15. Methode zum Lesen der Information, die in der Speicherschicht einer Magnetvorrichtung nach einem der vorangehenden Ansprüche enthalten ist, wobei die Speicherschicht eine Magnetisierung in stabiler Vortexkonfiguration aufweist, wobei die Methode einen Schritt des Anwendens eines Drehfelds auf die Magnetisierung der Referenzschicht aufweist, wobei das Drehfeld eine Oszillation des Widerstands des Stapels aufweist, und einen Schritt des Bestimmens der in der Speicherschicht geschriebenen Information auf der Basis der Phase und der Amplitude der Widerstandsoszillation.

## Claims

1. Magnetic device (1) with thermally assisted writing comprising at least one magnetic element including:

- a first magnetic layer referred to as "reference layer" (2);
- a second magnetic layer referred to as "storage layer" (4), the storage layer having a variable magnetisation configuration;
- a non-magnetic spacer (3) which separates the reference layer (2) and the storage layer (4) and magnetically decouples same;
- an antiferromagnetic trapping layer (5) in contact with the storage layer (4), this antiferromagnetic layer which can trap the magnetisation configuration of the storage layer;
- means (12) for heating said antiferromagnetic trapping layer (5) such that, during heating , the temperature of said antiferromagnetic trapping layer exceeds its blocking temperature such that, when hot, the magnetisation configuration of said storage layer (4) is no longer trapped;

said device (1) being **characterised in that** said reference layer (2) and said storage layer have a stable vortex magnetisation configuration and said device (1) comprises means (13, 14) for creating a magnetic field for reversibly moving the core of the vortex in the plane of said reference layer and said storage layer has a number of storage levels strictly greater than two, each storage level corresponding to a trapped magnetisation configuration.

2. Device according to the preceding claim **characterised in that** the vortices of said reference layer and of said storage layer have the same chirality.

3. Device according to one of the preceding claims **characterised in that** said storage layer has three storage levels.

4. Magnetic device according to one of the preceding claims **characterised in that** said means for creating a magnetic field comprise means for creating two variable non-parallel magnetic field components Hx and Hy, the simultaneous application of these field components Hx and Hy being able to move the core of the vortex of said storage layer in the plane of said storage layer when the latter is not trapped, each pair of components Hx and Hy being associated with a storage level.

5. Device according to one of the preceding claims **characterised in that** said reference layer and said storage layer have the same thickness and are made from the same material.

6. Device according to one of the preceding claims **characterised in that** it comprises a plurality of magnetic elements each forming a memory point, the vortices of the reference layers of said memory points all having the same chirality.

7. Device according to the preceding claim **characterised in that**, for a given radius of said memory point, the thickness of said reference layer is chosen in such a way that said reference layer has a stable vortex magnetisation configuration.

8. Device according to one of the preceding claims **characterised in that** the Curie temperature of said reference layer is reduced over at least one portion of the thickness of this reference layer to a value less than 900K but greater than 550K.

9. Device according to one of the preceding claims **characterised in that** said reference layer comprises a first sublayer in contact with said spacer and a second sublayer, the first sublayer having a Curie temperature greater than the second sublayer farther away from said spacer.

10. Device according to the preceding claim **characterised in that** said reference layer is a composite layer formed of at least two sublayers including a sublayer made of CoFeB in contact with the spacer made from MgO and a sublayer at a lower Curie temperature farther away from the spacer such as a sublayer made from NiFe or a NiFeX alloy where X represents a non-magnetic element such as Ta, Cu, Hf, Zr, Cr, V in a proportion of about 2 to 20%.

11. Device according to one of the preceding claims **characterised in that** said spacer is carried out according to one of the following forms:

- said spacer is a tunnel barrier;
- said spacer is carried out in the form of an insulating layer comprising a conductive contact;
- said spacer is made from a semiconductor or metal material;
- said spacer is a metal/heterogeneous oxide layer such as a current-confined path layer formed from an insulating barrier pierced with conductive channels.

12. Device according to claim 4 **characterised in that** said means for creating a magnetic field are able to move said vortex core with respect to the centre of said reference layer by a distance greater than the radius of said vortex core.

13. Device according to one of the preceding claims **characterised in that** said storage layer comprises at least one stack formed by:

- a magnetic layer formed from a ferromagnetic material having a centred face cubic crystallographic structure in contact with said antiferromagnetic layer;
- an amorphous or quasi-amorphous transition layer in contact with said layer of ferromagnetic material having a centred face cubic crystallographic structure;
- a ferromagnetic layer having a centred cubic crystallographic structure.

14. Magnetic device according to claim 6 **characterised in that** said at least one memory point is of substantially cylindrical shape.

15. Method for reading information contained in the storage layer of a magnetic device according to one of the preceding claims, said storage layer having a stable vortex magnetisation configuration, said method comprising a step of applying a rotating field on the magnetisation of the reference layer, said rotating field causing an oscillation in the resistance of the stack, and a step of determining the information written in the storage layer from the phase and the amplitude of said resistance oscillation.

Fig. 1

Fig. 2

**Fig. 3**

**Fig. 4**

Fig. 5a        Fig. 5b        Fig. 5c

**Fig. 6a**

**Fig. 6b**

**Fig. 6c**

**Fig. 7a**

**Fig. 7b**

**Fig. 7c**

EP 2 836 998 B1

EP 2 836 998 B1

**Fig. 8**

**Fig. 9a**      **Fig. 9b**      **Fig. 9c**

V(t)

**Fig. 10a**

V(t)

**Fig. 10b**

EP 2 836 998 B1

V

Si la couche de stockage
est en configuration "1"

**Fig. 11a**

t

Alignement local
presque parallèle partout

V

Si la couche de stockage
est en configuration "0"

**Fig. 11b**

t

Alignement local
presque parallèle partout

V

Si la couche de stockage
est en configuration "-1"

**Fig. 11c**

t

Fig. 12a Fig. 12b Fig. 12c Fig. 12d Fig. 12e

**Fig. 13**

**Fig. 14**

**Fig. 15**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2009147567 A
- FR 2817999
- EP 2276034 A
- US 6654278 B
- US 7072208 B
- US 2011110151 A

### Littérature non-brevet citée dans la description

- **KONSTANTIN et al.** Map of metastable states for thin circular magnetic nanocylinders. *Applied Physics Letters,* vol. 92, 112506-2008
- **J.SORT, G.SALAZAR-ALVAREZ ; M.D.BARO, B.DIENY ; A.HOFFMANN ; V.NOVOSAD ; J. NOGUES ; K.S. BUCHANAN ; A. BOLLERO.** Imprinting vortices into Antiferromagnets. *Phys. Rev. Lett,* 2006, vol. 97, 067201